Europäisches Patentamt

European Patent Office

Office européen des brevets

(11) Numéro de publication: **0 285 206 B1**

# (12) FASCICULE DE BREVET EUROPEEN

(45) Date de publication de fascicule du brevet:
**15.01.92**

(51) Int. Cl.⁵: **H01L 21/28**, H01L 29/60, H01L 29/80

(21) Numéro de dépôt: **88200513.5**

(22) Date de dépôt: **21.03.88**

(54) **Procédé de réalisation d'un dispositif semiconducteur du type transistor à effet de champ.**

(30) Priorité: **24.03.87 FR 8704072**

(43) Date de publication de la demande:
**05.10.88 Bulletin 88/40**

(45) Mention de la délivrance du brevet:
**15.01.92 Bulletin 92/03**

(84) Etats contractants désignés:
**DE FR GB NL**

(56) Documents cités:
**EP-A- 0 106 174**
**EP-A- 0 196 087**
**EP-A- 0 211 353**

**EXTENDED ABSTRACTS OF THE 17TH CONFERENCE ON SOLID STATE DEVICES AND MATERIALS, Tokyo, 25-27 août 1985, pages 413-416; T. ENOKI et al.: "Advanced GaAs SAINT FET fabrication techology and its application to above 9 GHz frequency divider"**

(73) Titulaire: **LABORATOIRES D'ELECTRONIOUE PHILIPS**
**3, Avenue Descartes**
**F-94450 Limeil-Brévannes(FR)**
(84) Etats contractants désignés:
**FR**

Titulaire: **N.V. Philips' Gloeilampenfabrieken**
**Groenewoudseweg 1**
**NL-5621 BA Eindhoven(NL)**
(84) Etats contractants désignés:
**DE GB NL**

(72) Inventeur: **Rabinzohn, Patrick Daniel**
**Société Civile S.P.I.D. 209 rue de l'Université**
**F-75007 Paris(FR)**
Inventeur: **Gourrier, Serge**
**Société Civile S.P.I.D. 209 rue de l'Université**
**F-75007 Paris(FR)**
Inventeur: **Rocher, Christian**
**Société Civile S.P.I.D. 209 rue de l'Université**
**F-75007 Paris(FR)**

IEEE TRANSACTIONS ON ELECTRON DEVI-CES, vol. ED-29, no. 11, novembre 1982, pages 1772-1777, IEEE, New York, US; K. YAMA-SAKI et al.: "GaAs LSI-directed MESFET's with self-aligned implantation for n+-layer technology (SAINT)"

PATENT ABSTRACTS OF JAPAN, vol. 9, no. 280 (E-356)[2003], 8 novembre 1985; & JP-A-60 123 026

1978 IEEE MTT-S INTERNATIONAL MICROWA-VE SYMPOSIUM DIGEST, Ottawa, 27-29 juin 1978, pages 309-311, IEEE, New York, US; P.T. CHEN et al.: "Dual-gate GaAs FET as a frequency multiplier at Ku-band"

(74) Mandataire: Landousy, Christian et al
Société Civile S.P.I.D. 156, Boulevard Haussmann
F-75008 Paris(FR)

# Description

L'invention concerne un procédé pour réaliser un dispositif semiconducteur du type transistor à effet de champ comprenant, formée en surface d'un substrat semiconducteur, une couche d'un premier type de conductivité d'un premier niveau de résistivité dite couche active sur laquelle est réalisée une électrode de grille de type Schottky, présentant dans sa partie inférieure la forme générale d'un trapézoïde dont la petite base est en contact avec la couche active, comprenant ensuite de part et d'autre de la couche active deux régions du même type de conductivité d'un second niveau de résistivité constituant les régions de source et de drain, régions dont les bords adjacents à la couche active sont alignés avec les arêtes de la grande base ou base supérieure du trapézoïde, et comprenant en outre des électrodes de source et de drain du type contact ohmique réalisées en surface des régions du premier type de conductivité d'un second niveau de résistivité.

L'invention concerne également le transistor obtenu par ce procédé.

L'invention trouve son application dans la réalisation de circuits intégrés aussi bien numériques qu'analogiques travaillant à des fréquences très élevées, ou montrant des fréquences de coupure très élevées, de l'ordre de plusieurs dizaines de GHz, à forte densité d'intégration, et fort rendement de fabrication.

Un procédé de réalisation pour obtenir un transistor à effet de champ, tel que décrit précédemment, est connu de EP-A-0 196 087.

Le transistor décrit dans ce document présente un certain nombre d'inconvénients dû au procédé mise en oeuvre.

Tout d'abord, l'électrode de grille est réalisée en un métal réfractaire tel que WSi, donc très résistif. En effet, dans le procédé décrit, le contact de grille est réalisé dans une étape antérieure à la réalisation des régions de source et drain et sert de masque pour l'implantation d'ions aptes à former ces régions. Le métal qui constitue ce contact de grille doit donc être suffisamment réfractaire pour supporter le recuit d'implantation qui est de l'ordre de 800°C pendant 20 mn. La forte résistivité de ce métal réfractaire diminue les performances de bruit du transistor à effet de champ, le rendant non compatible à la réalisation de circuits bas-bruit ou de circuit intégrés analogiques. Pour la réalisation de tels circuits, l'obtention de transistors dont la grille présente une faible résistivité est donc primordiale.

De plus, bien que réfractaire, le métal choisi ne l'est cependant pas suffisamment pour éviter une certaine instabilité de l'interface métal-semiconducteur durant le recuit d'implantation.

Le procédé connu du document cité a pour objectif de permettre la réalisation d'un transistor à grille submicronique. Cette dimension de la grille est obtenue du fait que cette dernière présente la forme d'un trapézoïde dont la petite base est en contact avec la couche active, alors que la grande base sert de masque pour l'autoalignement des régions implantées de source et de drain. Mais cette forme trapézoïdale est obtenue par une gravure par faisceau d'ions sous un angle très petit donné, procédé qui présente l'inconvénient de ne pas être répétitif. En effet, d'une part la vitesse d'érosion dépend de l'angle d'attaque, lequel varie obligatoirement au fur et à mesure de la gravure, et d'autre part il se forme lors de la gravure un redépôt au pied du trapézoïde qui fait que la forme trapézoïdale attendue ne peut être obtenue. L'obtention du dispositif décrit est donc théorique et non pas réaliste.

Or, des variations même faibles de la longueur de grille, lorsque cette longueur atteint des dimensions submicroniques, provoquent des variations importantes de la tension de seuil d'un transistor à l'autre qui sont particulièrement néfastes à la réalisation de circuits intégrés ultra-rapides.

En outre, selon le procédé connu du document cité, la grande base du trapézoïde inversé sert également de masque pour l'autoalignement des contacts ohmiques de source et drain. Mais un tel alignement est extrêmement délicat, et il arrive fréquemment, vu les distances extrêmement réduites entre la grille et les contacts de source et drain, que des courts-circuits apparaissent entre ces électrodes, ce qui réduit le rendement de fabrication. Il faut être bien conscient qu'en fabrication de circuits intégrés, si un seul transistor d'un circuit sur une plaquette ne fonctionne pas, alors que ce dernier en comprend plusieurs centaines ou plusieurs milliers, c'est l'ensemble du circuit de la plaquette qui doit être rejeté. Le procédé de fabrication doit donc être aussi fiable que possible.

La présente invention vise à fournir un dispositif semiconducteur et un procédé de réalisation qui est exempt de ces inconvénients.

Selon l'invention, ce but est atteint au moyen d'un procédé de réalisation comprenant au moins les étapes de:

a/ formation d'un substrat W d'un matériau semiconducteur monocristallin, présentant une face orientée parallement à un plan cristallographique ;

b/ réalisation en surface de ce substrat d'une couche en un matériau diélectrique d'une première sorte ;

c/ réalisation en surface de la couche précédente d'un masque $M_2$ délimitant la grande base du trapézoïde constituant la partie dite inférieure de l'électrode de grille ;

d/ gravure autour du masque $M_2$, de la couche diélectrique de la première sorte, par gravure ionique réactive (RIE), pour obtenir un plot $M_1$ en diélectrique de la première sorte surmonté du masque $M_2$ ;

e/ implantation autour du plot $M_1$ servant de masque et dans l'ouverture d'un masque $M_0$ délimitant la périphérie du transistor, d'ions aptes à former les régions de source et de drain du premier type de conductivité du second niveau de résistivité, puis élimination des masques $M_0$ et $M_2$ ;

f/ dépôt en surface du dispositif seulement muni du plot $M_1$ d'une couche d'épaisseur uniforme au moins égale à celle du plot $M_1$, en matériau diélectrique d'une seconde sorte ;

g/ planarisation par une méthode connue en soi, du dispositif au niveau de la surface supérieure du plot $M_1$ ;

h/ élimination par gravure ionique réactive sélective du plot $M_1$, de façon à former une ouverture de même surface dans la couche diélectrique de la seconde sorte, mettant à nu le substrat W ;

i/ implantation dans cette ouverture en outre délimitée par le masque $M_0$, d'ions aptes à former la couche active du premier type de conductivité du premier niveau de résistivité, recuit d'implantation, et élimination du masque $M_0$ ;

j/ réalisation par une méthode connue en soi d'espaceurs appuyés sur les flancs de l'ouverture pratiquée dans la couche du diélectrique de la seconde sorte, ces espaceurs étant du diélectrique de la seconde sorte, et leur épaisseur étant prévue pour réduire les dimensions de l'ouverture aux dimensions voulues pour la longueur de grille L du transistor et pour définir en même temps la distance qui sépare l'électrode de grille des régions de source et drain ;

k/ dépôt d'une couche du métal de grille d'épaisseur supérieure à celle de la couche du diélectrique de la seconde sorte, puis d'une couche choisie parmi le diélectrique de la première sorte ou le titane (Ti), ces couches étant d'épaisseur uniforme ;

l/ planarisation par une méthode connue en soi du dispositif jusqu'au niveau supérieur de la couche du métal de grille, de telle sorte que subsiste aussi, en surface de la dépression formée dans la couche métallique de grille audessus de l'ouverture de la couche diélectrique de la seconde sorte, une couche du diélectrique de la première sorte ou de titane constituant un masque $M_3$ ;

m/ gravure autour du masque $M_3$ de la couche métallique de grille par une méthode choisie parmi la gravure ionique réactive sélective (RIE) ou la gravure par faisceau d'ions de gaz neutre, cette méthode étant choisie selon le métal constituant cette couche, jusqu'au niveau supérieur de la couche du matériau diélectrique de la seconde sorte, pour former la région centrale métallique de la partie dite supérieure de la grille ;

n/ réalisation par une technique connue en soi, d'espaceurs appuyés sur les flancs de la couche métallique de grille, pour former une région diélectrique périphérique à la partie métallique supérieure de la grille, surplombant la couche diélectrique de la seconde sorte, ces espaceurs étant en diélectrique de la première sorte, et leur épaisseur étant prévue pour définir la distance qui sépare les électrodes de source et drain de la couche active, en sorte que la distance qui sépare l'électrode de grille des électrodes de source et drain égale la somme des épaisseurs des espaceurs mis en oeuvre dans le procédé ;

o/ gravure de la couche du diélectrique de la seconde sorte par gravure ionique réactive sélective, autour du plot formé par la partie supérieure de grille couverte du masque $M_3$ et des espaceurs en diélectrique de la première sorte, jusqu'au niveau supérieur du substrat, cette gravure pouvant éventuellement être légèrement prolongée latéralement sous les espaceurs.

Ce procédé de réalisation peut en outre se poursuivre par l'étape :

p/ dépôt en surface du dispositif précédent, le masque $M_3$ étant en titane (Ti), dans l'ouverture du masque $M_0$ définissant la périphérie du transistor, d'une couche d'un métal apte à former un contact ohmique avec le matériau semiconducteur pour constituer les contacts de source S et drain D, et élimination du masque $M_0$. Ou bien, ce procédé de réalisation peut se poursuivre par l'étape :

p'/ dépôt en surface du dispositif précédent, le masque $M_3$ étant en titane (Ti) ou bien en diélectrique da la première sorte, dans l'ouverture du masque $M_0$ définissant la périphérie du transistor, d'une couche d'un métal apte à former un contact ohmique avec le matériau semiconducteur et élimination du masque $M_0$ et des régions diélectriques de la première sorte, entraînant par un procédé connu en soi de LIFT-OFF les couches métalliques déposées sur ces couches diélectriques.

Le concept de l'invention peut aussi s'appliquer à un procédé de réalisation d'un transistor à effet de champ dont l'électrode de grille comporte plusieurs doigts.

Ainsi le procédé selon l'invention permet la réalisation d'un dispositif semiconducteur du type transistor à effet de champ comprenant formée en surface d'un substrat semiconducteur des couches d'un premier type de conductivité d'un permier niveau de résistivité dites couches actives sur lesquelles sont réalisées des électrodes de grille G de type Schottky présentant dans leur partie dite inférieure la forme générale d'un trapézoïde dont la petite base est en contact avec une couche active, comprenant ensuite entre chaque couche active une région d'un premier type de conductivité, d'un second niveau de résistivité, et, de part et d'autre des couches actives extrêmes, deux régions du premier type de conductivité d'un second niveau de résistivité constituant les régions de source et de drain, régions dont les bords adjacents à ces couches actives sont alignés avec les arêtes de la grande base ou base supérieure des trapézoïdes des grilles correspondantes, et comprenant en outre des électrodes de source S et de drain D du type contact ohmique réalisées en surface des régions extrêmes du premier type de conductivité d'un second niveau de résistivité.

Pour atteindre ce but, le procédé comprend alors les étapes suivantes :

a'/ formation d'un substrat W d'un matériau semiconducteur monocristallin, présentant une face orientée parallement à un plan cristallographique ;

b'/ réalisation en surface de ce substrat d'une couche en un matériau diélectrique d'une première sorte ;

c'/ réalisation en surface de la couche précédente d'un masque $M_2$ délimitant plusieurs doigts correspondant à la grande base de chaque trapézoïde constituant la partie inférieure de chaque électrode de grille ;

d'/ gravure autour du masque $M_2$, de la couche diélectrique de la première sorte, par gravure ionique réactive (RIE) pour obtenir un plot $M_1$ en diélectrique de la première sorte surmonté du masque $M_2$ et de même forme que ce dernier ;

e'/ implantation autour du plot $M_1$ servant de masque et dans l'ouverture d'un masque $M_0$ délimitant la périphérie du transistor, d'ions aptes à former les régions du premier type de conductivité du second niveau de résistivité, puis élimination des masques $M_0$ et $M_2$ ;

f'/ dépôt en surface du dispositif seulement muni du plot $M_1$ d'une couche d'épaisseur uniforme au moins égale à celle du plot $M_1$, en matériau diélectrique d'une seconde sorte ;

g'/ planarisation par une méthode connue en soi, du dispositif au niveau de la surface supérieure du plot $M_1$ ;

h'/ élimination par gravure ionique réactive sélective du plot $M_1$, de façon à former des ouvertures de mêmes formes et surface dans la couche diélectrique de la seconde sorte, mettant à nu le substrat W ;

i'/ implantation dans ces ouvertures en outre délimitée par le masque $M_0$, d'ions aptes à former les couches actives du premier type de conductivité du premier niveau de résistivité, recuit d'implantation, et élimination du masque $M_0$ ;

j'/ réalisation par une méthode connue en soi d'espaceurs appuyés sur les flancs des ouvertures pratiquées dans la couche du diélectrique de la seconde sorte, ces espaceurs étant du diélectrique de la seconde sorte, et leur épaisseur étant prévue pour réduire les dimensions des ouvertures aux dimensions voulues pour la longueur des doigts de grille L du transistor et pour définir en même temps la distance qui sépare les doigts de grille extrêmes des régions de source et drain ;

k'/ dépôt d'une couche du métal de grille d'épaisseur supérieure à celle de la couche du diélectrique de la seconde sorte, puis d'une couche choisie parmi le diélectrique de la première sorte ou le titane (Ti), ces couches étant d'épaisseur uniforme ;

l'/ planarisation par une méthode connue en soi du dispositif jusqu'au niveau supérieur de la couche du métal de grille, de telle sorte que subsiste aussi, en surface de la dépression formée dans la couche métallique de grille audessus de l'ouverture de la couche diélectrique de la seconde sorte, une couche du diélectrique de la première sorte ou de titane constituant un masque $M_3$ ;

m'/ gravure autour du masque $M_3$ de la couche métallique de grille par une méthode choisie parmi la gravure ionique réactive (RIE) sélective ou la gravure par faisceau d'ions de gaz neutre, cette méthode étant choisie selon le métal constituant cette couche, jusqu'au niveau supérieur de la couche du matériau diélectrique de la seconde sorte, pour former la région centrale métallique de la partie dite supérieure des doigts de grille ;

n'/ réalisation par une technique connue en soi, d'espaceurs appuyés sur les flancs de la couche métallique de la partie métallique supérieure des doigts de grille, surplombant la couche diélectrique de la seconde sorte, ces espaceurs étant en diélectrique de la première sorte, et leur épaisseur étant prévue d'une part pour définir la distance qui sépare les électrodes de source et drain des zones actives adjacentes, en sorte que la distance qui sépare l'électrode de source et un doigt de grille ou un doigt de grille et l'électrode de drain égale la somme des épaisseurs des espaceurs mis en oeuvre dans le procédé, et leur épaisseur étant prévue d'autre part pour que les espaceurs de la partie supérieure de grille de deux doigts de grille adjacents soient en contact en sorte que la distance entre deux doigts de grille adjacents égale la double somme des épaisseurs des espaceurs mis en oeuvre dans le procédé ;

o'/ gravure de la couche du diélectrique de la seconde sorte par gravure ionique réactive sélective, autour du plot formé par la partie supérieure de grille couverte du masque $M_3$ et des espaceurs en diélectrique de la première sorte, jusqu'au niveau supérieur du substrat ;

p'/ dépôt en surface du dispositif précédent, le masque $M_3$ étant en titane (Ti) ou bien en diélectrique de la première sorte, dans l'ouverture du masque $M_0$ définissant la périphérie du transistor, d'une couche d'un métal apte à former un contact ohmique avec le matériau semiconducteur pour former les contacts de source S et drain D puis élimination du masque $M_0$ et des régions diélectriques de la première sorte et éventuellement $M_3$, entraînant par un procédé connu en soi de LIFT-OFF les couches métalliques déposées sur ces couches diélectriques.

Le dispositif obtenu par le procédé selon l'invention présente alors, entre autres, les avantages suivants :

- Le transistor conforme à l'invention peut présenter un contact de grille dont la longueur est très inférieure au $\mu$m ; et cette longueur de grille peut être diminuée autant qu'il est approprié, car elle est définie d'une façon très répétitive par une ouverture entre deux portions de couche diélectrique et non pas par gravure d'un plot métallique.
- La grille peut être constituée d'un métal peu résistif car elle n'a pas, au cours du procédé de réalisation à supporter des températures aussi élevées que celle d'un recuit d'implantation et n'a donc pas besoin d'être constituée d'un métal réfractaire. En fait, le choix des matériaux pour réaliser le dispositif n'est lié à aucune condition technologique contraignante.
- La résistance de la grille est encore diminuée du fait que la surface de la section de la grille est grande, bien que la longueur de grille soit petite. La surface supérieure de la grille sur laquelle est pris le contact est également grande.
- L'épaisseur de grille peut être très grande ce qui supprime l'étape de réépaississement de grille incluse dans les procédés selon l'art antérieur.
- La longueur de grille des transistors est très répétitive d'un transistor à l'autre. Les transistors obtenus peuvent être utilisés aussi bien dans les circuits numériques que dans les circuits analogiques.
- Les court-circuits entre la grille et les autres contacts sont impossibles du fait qu'il sont isolés par des zones diélectriques.
- Tous les éléments du transistor -régions de drain, de source, de grille, les électrodes de source et de drain- sont autoalignés les uns par rapport aux autres, ce qui permet d'obtenir un transistor particulièrement compact, et donc une grande densité d'intégration.
- Les bords des électrodes de source et de drain ne sont pas alignés sur le bord des régions implantées de source et drain, mais sont légèrement plus éloignés de la grille du fait qu'ils sont autoalignés sur le bord de la région périphérique diélectrique de grille, ce qui augmente le rendement de fabrication en diminuant les risques de court-circuit, sans diminuer cependant la compacité du dispositif.

Ce procédé selon l'invention présente lui-même, entre autres, les avantages suivants :
- le nombre de masques nécessaires à la définition du transistor est réduit à deux, $M_0$ et $M_2$, ce qui est bien inférieur au nombre de masques généralement nécessaires à la définition d'un transistor, typiquement 5 à 7 ;
- le procédé est très fiable. Le rendement de fabrication très élevé. Les transistors sont très répétitifs et leurs performances montrent une très faible dispersion d'un transistor à l'autre ;
- aucune sous-gravure, considérée comme une méthode peu reproductible, n'est utilisée dans ce procédé ;
- tous les éléments sont autoalignés et non pas simplement alignés ;
- aucune gravure chimique n'est utilisée mais au contraire des gravures ioniques réactives ;
- toutes les étapes de fabrication peuvent être pratiquement faites dans la même enceinte ;
- toutes les gravures ioniques réactives nécessaires peuvent être réalisées, du fait du choix des matériaux constituant le transistor, au moyen de deux gaz ou associations de gaz seulement.

L'invention sera mieux comprise au moyen de la description suivante illustrée par les figures annexées dont :
- la figure 1a qui représente schématiquement le dispositif semiconducteur selon l'invention, en coupe selon l'axe I-I de la figure 1b,
- les figures 1b, 1c et 1d qui représentent schématiquement le dispositif semiconducteur selon l'invention, vu du dessus,
- les figures 2a à 2n qui représentent le dispositif selon l'invention dans les différentes étapes du procédé de réalisation, en coupe schématique,
- les figures 3a et 3b qui représentent les étapes de formation d'un espaceur, en coupe schématique,

- les figures 4a et 4b qui représentent les étapes du procédé de réalisation d'un transistor bi-grille,
- les figures 5a et 5b qui représentent les étapes du procédé de réalisation d'un transistor à régions de source et drain d'épaisseur variable.

Dans la description qui suit, par "autoalignement" il faut entendre un procédé de réalisation qui utilise un élément du transistor comme référence, par exemple comme masque, pour former un autre élément du transistor. Il est clair que la réalisation d'éléments au moyen d'un procédé d'autoalignement est plus précise, plus répétitive, présente une meilleure définition, et diminue le nombre d'étapes nécessaires, comparée à la réalisation de ces éléments au moyen d'un procédé d'alignement simple, c'est-à-dire à l'aide de masques.

Par "sous-gravure" il faut entendre, dans un procédé incluant la gravure d'une couche protégée par un masque, la gravure latérale du matériau de la couche qui intervient sous le masque, gravure latérale qui est d'une dimension équivalente à celle de la gravure qui intervient en même temps dans la direction perpendiculaire. Une telle sous-gravure est en général obtenue par voie humide, c'est-à-dire par l'action de composés chimiques liquides. Or dans la mise en oeuvre d'une fabrication de circuits intégrés, ce n'est pas un seul transistor qui est réalisé mais plusieurs centaines répartis sur toute la surface d'une plaquette pour former un circuit. La gravure chimique des éléments situés au bord de la plaquette n'est jamais équivalente à la gravure chimique des éléments situés au centre de la plaquette. Une telle sous-gravure est également possible par gravure ionique réactive. Mais elle est difficile à maîtriser et non uniforme sur l'ensemble d'une plaquette. C'est pourquoi ces procédés sont particulièrement évités dans le procédé de réalisation du dispositif selon l'invention.

Un procédé de réalisation permettant d'obtenir des transistors à faible résistance de grille est connu de la publication intitulée "GaAs LSI-Directed MESFET'S with Self-Aligned Implantation for $n^+$-layer Technology (SAINT)" dans IEEE Vol.ED-29, N° 11, Nov.82, par KIMIYOSHI YAMASAKI et alii. Mais les transistors réalisés par la méthode décrite dans ce document montrent justement une grille définie par une sous-gravure, ce qui doit avant tout être évité pour les raisons citées plus haut. Le procédé décrit comprend l'élaboration d'une grille fictive qui occupe l'emplacement de la grille définitive durant l'implantation des régions de source et drain. Cette grille fictive est donc réalisée au moyen d'une sous-gravure. Elle est éliminée dans une étape ultérieure du procédé et remplacée par la grille définitive.

La présente invention propose aussi un transistor à faible résistance de grille, grille submicronique et structure compacte mais dont le procédé de réalisation est plus répétitif et plus simple.

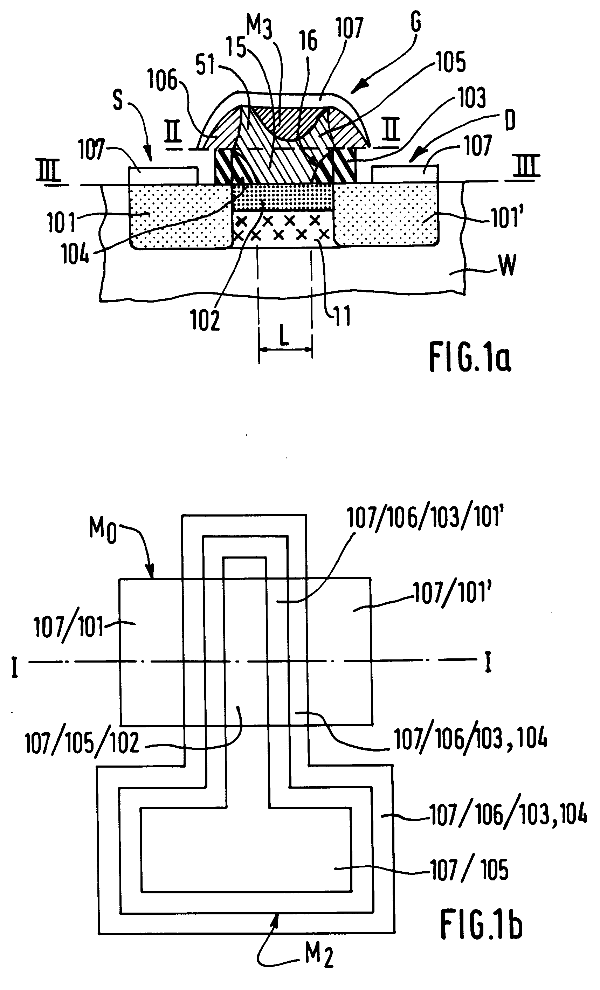

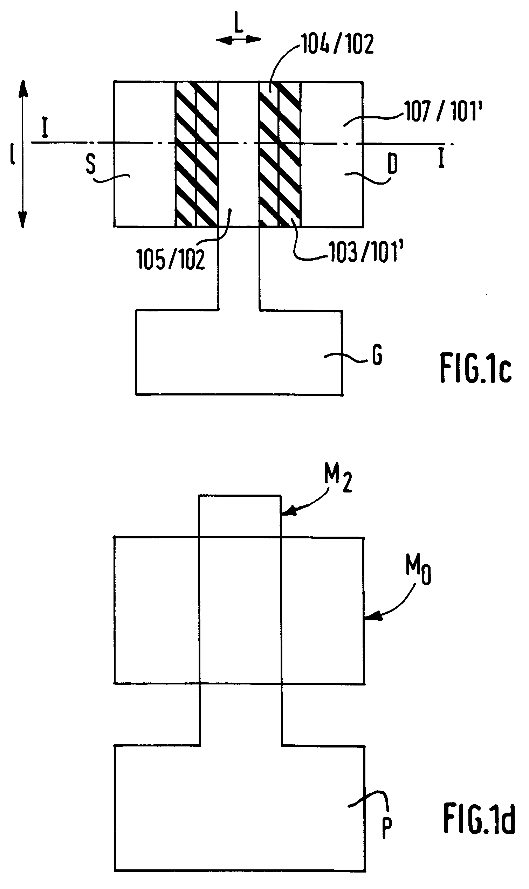

Tel que représenté vue du dessus sur la figure 1c dans le plan III-III de la figure 1a, le dispositif selon l'invention constitue un transistor à effet de champ du type MESFET (de l'anglais : MEtal-Semiconductor Field Effect Transistor) comprenant une électrode de grille G, une électrode de source S, une électrode de drain D réalisées en surface d'un substrat semiconducteur W.

Tel que représenté sur la figure 1a, en coupe selon l'axe I-I de la figure 1c ce dispositif comprend un substrat semiconducteur monocristallin orienté W, présentant une face orientée parallèlement à un plan cristallographique sur laquelle sont réalisés les différents éléments du transistor.

Ce substrat W est de préférence en un composé du groupe III-V tel que par exemple l'arséniure de gallium (GaAs) qui est particulièrement favorable à la réalisation de dispositifs hyperfréquences ou à grande vitesse de fonctionnement. Le substrat W est choisi par exemple semi-isolant.

Le transistor selon l'invention est formé en surface de ce substrat W. Il comprend une couche active 102 d'un premier type de conductivité et d'un premier niveau de résistivité et deux régions de source et de drain 101 et 101' du même type de conductivité et d'un second niveau de résistivité disposées de part et d'autre de la région 102 du premier niveau de résistivité. Accessoirement, ce transistor peut comporter une région 11 d'un second type de conductivité disposée sous la couche active.

Favorablement la couche active sera de type n, les régions de source et de drain seront de type $n^+$ et la couche 11, disposée sous la couche active 102, sera de type p.

Ce transistor comprend ensuite, en surface de la couche active 102, l'électrode de grille G constituée d'une couche métallique 105 propre à réaliser un contact de type Schottky avec le matériau semiconducteur. En ce qui concerne sa forme, la grille G présente une partie inférieure 15 et une partie supérieure 51 délimitées par l'axe II-II.

La partie inférieure 15 montre une forme à peu près trapézoïdale dont les faces latérales 16 sont cependant légèrement incurvées. La petite base du trapézoïde ou base inférieure est en contact avec la couche active 102 du matériau semiconducteur, et ses arêtes définissent les dimensions de l'électrode de grille :

- sa longueur L, qu'il est recherché d'obtenir inférieure au $\mu$m, et qui est dans le plan de la figure 1a ;

- sa largeur $\ell$, supérieure au $\mu$m et perpendiculaire au plan de la figure 1a (voir figure 1c).

Les arêtes de la grande base du trapézoïde, ou base supérieure, qui sont perpendiculaire au plan de la figure 1a et parallèles à la largeur $\ell$ de la grille G, sont autoalignées avec les bords des régions 101 et 101' de source et drain adjacentes à la couche active 102.

La partie supérieure 51 de la grille G comporte une région centrale constituée de la couche métallique 105 et une région périphérique 106 en un matériau diélectrique d'une première sorte.

La région périphérique 106 déborde autour de la surface supérieure ou grande base du trapézoïde et surplombe une couche diélectrique formée des parties 103 et 104. Les électrodes de source S et de drain D formées de la couche métallique 107 sont autoalignées avec le bord extérieur de la région périphérique 106. La couche 103 et 104 est en une seconde sorte de matériau diélectrique et la couche 107 est en un alliage propre à former un contact de type ohmique avec le matériau semiconducteur.

Avantageusement la couche métallique 105 formant le contact de grille est une multicouche comprenant superposées soit :

- une couche de tungstène (W) d'épaisseur environ 200 nm, une couche de tantale (Ta) d'épaisseur environ 100 nm et une couche supérieure d'or (Au) d'épaisseur supérieure à 500 nm, ou bien :
- une couche de nitrure de tungstène (WN), d'épaisseur environ 200 nm, une couche de nitrure de tantale (TaN) d'épaisseur environ 100 nm, et une couche supérieure d'or (Au) d'épaisseur supérieure à 500 nm, ou bien
- une couche de tungstène (W) d'épaisseur environ 100 nm, et une couche supérieure d'or (Au) d'épaisseur supérieure à 500 nm.

Selon cette disposition avantageuse d'une multicouche pour former la métallisation de grille de type Schottky, une couche de tungstène de faible épaisseur par rapport à l'ensemble de l'épaisseur de la multicouche est utilisée et disposée en contact avec la couche active du matériau semiconducteur. L'utilisation de ce matériau réfractaire en faible épaisseur est prévue pour obtenir une bonne stabilité en température de l'interface métal-semiconducteur sans toutefois rendre la grille résistive. En effet, si le procédé de réalisation décrit plus loin est axé sur le fait que les recuits d'implantation réalisés à forte température sont terminés avant la réalisation de la métallisation de grille, néanmoins cette métallisation est déjà en place lorsque le dispositif est porté à la température d'alliage des métaux de contact ohmique. Si la stabilité du tungstène était à sa limite pour supporter le recuit d'implantation (800°C), elle est alors au contraire parfaite, même lorsque le tungstène est en couche mince, lors de la formation de l'alliage de contact ohmique (environ 450°C).

D'autre part, dans cette réalisation préférentielle du dispositif selon l'invention, la première sorte de diélectrique formant la région périphérique supérieure de la grille est choisie en silice ($SiO_2$) et la seconde sorte de diélectrique formant la couche isolant la grille des autres électrodes est choisie en nitrure de silicium ($Si_3N_4$).

Le choix de ces diélectriques différents va permettre de réaliser des gravures sélectives de l'un par rapport à l'autre, alors que le choix des métaux formant la grille, outre les avantages précités va permettre une gravure du métal de grille par la même méthode que celle qui permet de graver le nitrure de silicium et dans une suite d'opérations ininterrompues.

Dans cette réalisation préférentielle du dispositif selon l'invention, les électrodes de source et drain sont constituées d'un alliage or-germanium-nickel (Au-Ge-Ni) formant une couche d'épaisseur 0,5 à 1 $\mu$m réalisant avec le matériau semiconducteur, un contact ohmique.

Différentes variantes du dispositif selon l'invention sont possibles.

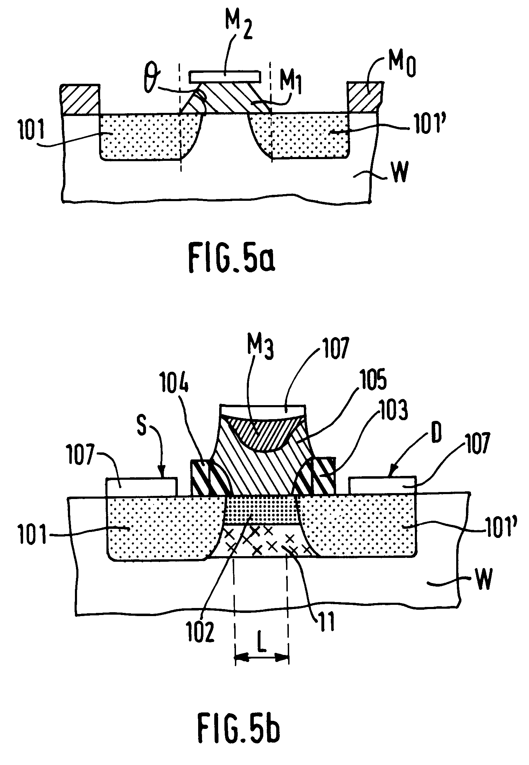

Selon une première variante, la partie supérieure de la grille peut être converte d'une couche $M_3$ de titane (Ti) d'épaisseur environ 100 nm (ce qui est le cas du dispositif représenté fig. 1a et fig. 5b).

Selon une seconde variante, avec ou sans la couche $M_3$ de titane précédente, la grille peut être couverte d'une couche du métal (107) de contact ohmique, ce qui est le cas du dispositif représenté fig. 1a et fig. 5b.

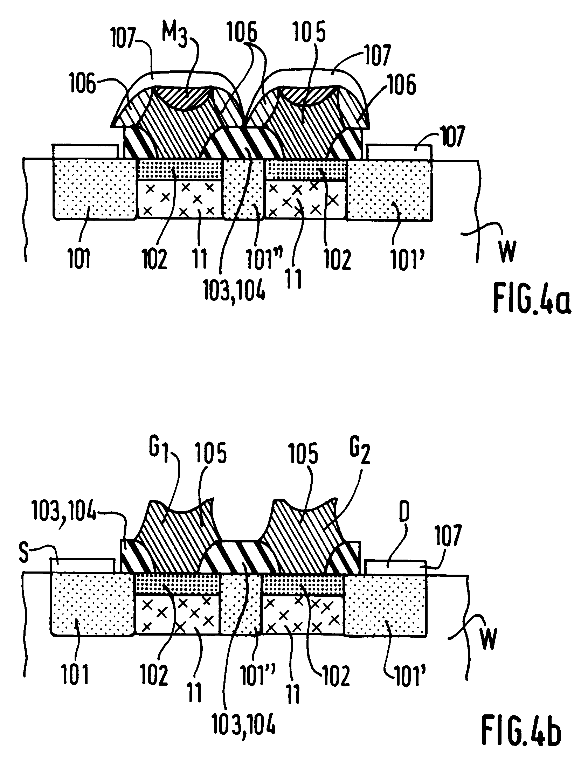

Dans une troisième variante, la région périphérique 106 peut être éliminée, entraînant avec elle les couches métalliques qui la recouvre éventuellement (procédé connu sous le nom de LIFT-OFF) (voir fig.5b et fig.4b).

Dans cette dernière variante (voir figure 4b), le dispositif selon l'invention peut être un transistor bigrilles (ou multi-grilles). En effet ce dispositif peut comprendre deux ou plusieurs électrodes $G_1$, $G_2$... de grille disposées entre les électrodes de source et de drain, ces électrodes de grille étant éloignées les unes des autres d'une distance double de la dimension transversale de la région périphérique diélectrique (voir figure 4a). Ainsi avant l'élimination des régions périphériques 106, les régions périphériques de deux grilles contiges sont en contact. Les régions périphériques sont éliminées en fin de procédé de réalisation pour éliminer par LIFT-OFF les couches métalliques qui les recouvrent et éviter ainsi les court-circuits entre les diverses métallisations de grille. Si la couche $M_3$ est en silice, l'ensemble de la métallisation 107 déposée sur les grilles est éliminé (fig.4b).

Dans un tel dispositif bi ou multi-grilles, chaque grille est réalisée en surface d'une couche active 102, et chaque couche active du premier type de conductivité du premier niveau de résistivité est séparée d'une autre par une région du même type de conductivité du second niveau de résistivité 101″. En outre chaque grille est séparée de la grille contige par une couche de matériau diélectrique de la seconde sorte 103, 104.

Des dimensions de transistors particulièrement aptes à former des circuits intégrés numériques ou analogiques sont les suivantes :

Longueur de grille L : inférieur au $\mu$m.

Distance entre régions du second type de conductivité mesurée dans le plan de la figure 1a : de 1 à 2 $\mu$m.

Distance entre contact ohmique et grille mesurée dans le plan de la figure 1a : de 0,5 à 2 $\mu$m.

Profondeur d'implantation de la couche active du premier type de conductivité : 50 à 300 nm.

Profondeur d'implantation des régions de drain et source du premier type de conductivité du second niveau de résistivité : 100 à 500 nm.

Dans une autre variante du dispositif (voir fig.5b) selon l'invention les régions 101 et 101' de source et drain sont prévues de profondeur progressive à partir de celle de la couche active 102. Cette technique permet entre autres de diminuer les résistances d'accès du transistor et également d'améliorer les effets défavorables dûs à l'étroitesse du canal. Ces derniers effets sont en outre atténués par l'implantation de la région 11 du second type de conductivité.

Selon la présente invention est proposé un procédé de réalisation avantageux pour obtenir ce dispositif.

Ce procédé comprend les étages suivantes :

a/ Formation d'un substrat W d'un matériau semiconducteur monocristallin, présentant une face orientée parallèlement à un plan cristallographique. Favorablement ce substrat sera en arséniure de gallium (GaAs) et la face sera orientée parallèlement au plan cristallographique (100).

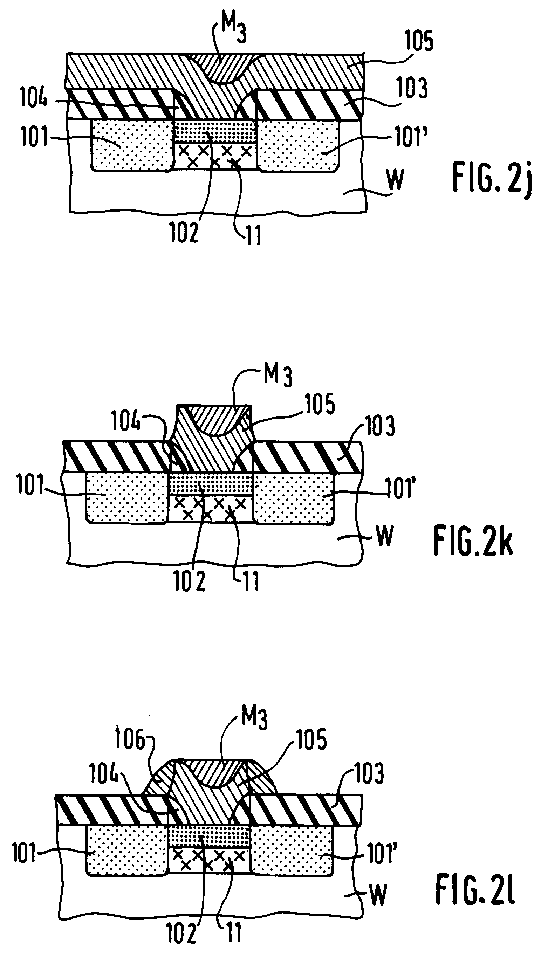

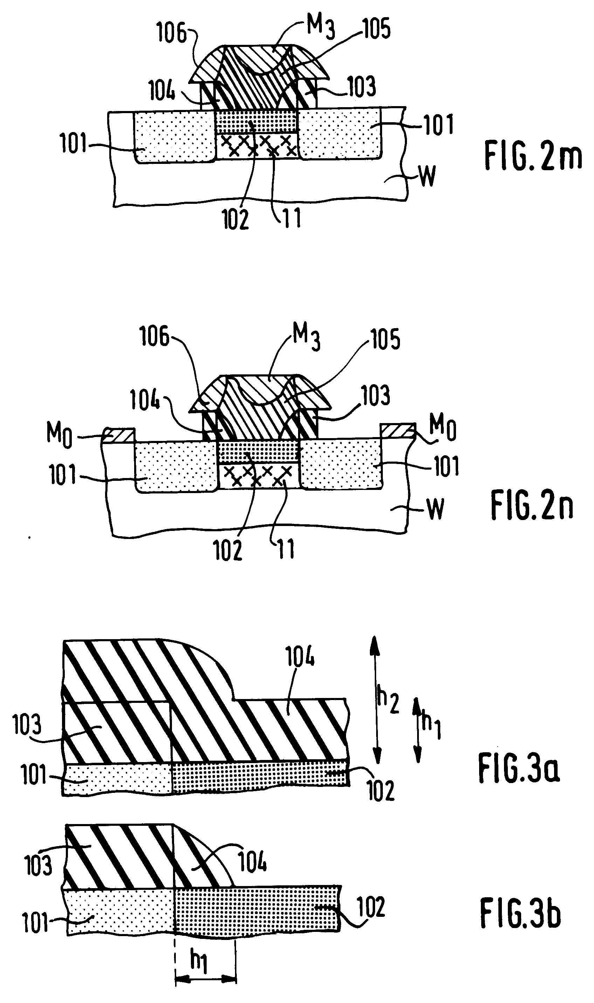

b/ Réalisation d'une couche 1 en un matériau diélectrique d'une première sorte. Cette couche pourra avoir 100 à 500 nm d'épaisseur et être constituée de silice (SiO$_2$) (voir fig.2a).

c/ Réalisation en surface de la couche 1 d'un masque M$_2$, par exemple en laque photosensible d'épaisseur 500 à 1000 nm. La dimension de ce masque le long de l'axe I-I de la figure 1b étant de l'ordre de 1 à 2 $\mu$m, sa réalisation est peu critique. Cette dimension définit la distance séparant les régions 101 et 101' de source et drain. Ce masque M$_2$ délimite en outre le plot P de prise de contact de grille comme montré vu du dessus figures 1b et 1d. D'une façon générale, ce masque M$_2$ a la forme et les dimensions de la grande base du trapézoïde formant la région inférieure (15) de la grille.

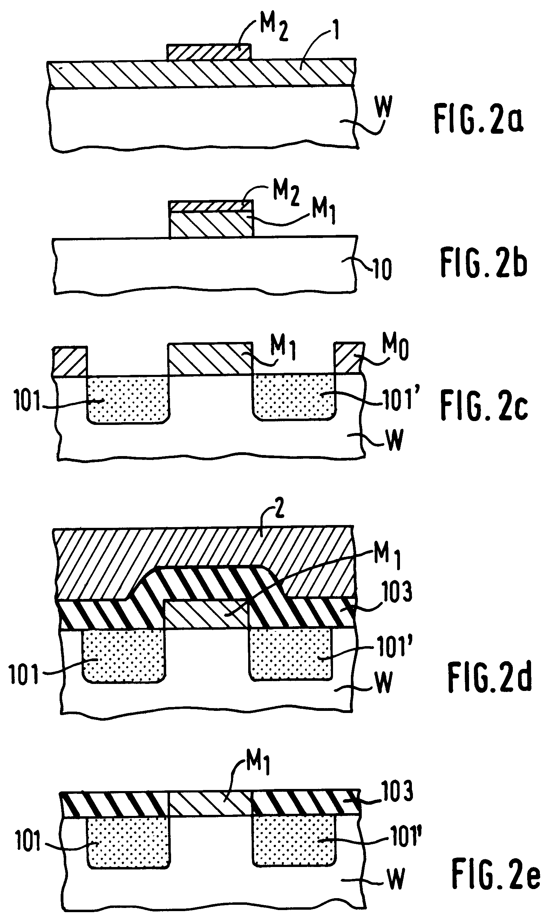

d/ Gravure, autour du masque M$_2$, de la couche diélectrique 1 de la première sorte, pour obtenir un plot M$_1$. Lorsque le diélectrique choisi pour la couche 1 est la silice, cette gravure est effectuée par gravure ionique réactive (RIE) à l'aide de gaz CHF$_3$ ou CF$_4$ purs (voir fig.2b). Dans cette réalisation les régions de source et drain 101 et 101' seront d'épaisseur constante. Par cette gravure le plot M$_1$ a les mêmes dimensions que le masque M$_2$.

d$_0$/ Cette étape est une alternative à l'étape d/ précédente et permet d'obtenir des régions de source et drain 101 et 101' d'épaisseur croissante à partir de la couche active 102 comme montré figure 5a et suivante. A cet effet, la gravure de la couche diélectrique 1 est réalisée sous des conditions différentes, par exemple au moyen de gaz différents de façon à obtenir d'une part une légère gravure latérale du masque M$_2$, et ensuite un plot M$_1$ présentant des faces latérales qui font avec la surface du semiconducteur un angle $\theta$ de l'ordre de 40 à 80°. Lorsque la couche diélectrique 1 est en silice (SiO$_2$), cette disposition est obtenue par une gravure ionique réactive (RIE) au moyen de gaz par exemple SF$_6$ ou O$_2$, en mélange avec CHF$_3$ ou CF$_4$.

e/ Implantation autour du plot M$_1$ servant de masque, et dans l'ouverture d'un masque M$_0$ délimitant la périphérie du transistor, d'ions aptes à former les régions 101 et 101' de source et drain du premier type de conductivité du second niveau de résistivité (voir figures 5a et 2c). Le masque M$_0$ peut être en laque photosensible ou en diélectrique de la seconde sorte. Dans ce dernier cas, il restera en place durant tout le procédé de réalisation. Pour obtenir des régions de type n$^+$ dans l'arséniure de gallium, il peut être implanté des ions silicium (Si) à une concentration de l'ordre de 10$^{17}$ à 10$^{18}$ au cm$^3$. Si les flancs du plot M$_1$ sont en pente, la profondeur de pénétration des ions diminue à partir du pied de la pente pour devenir faible dans la région correspondant au haut de la pente, ce qui permet d'obtenir la variation d'épaisseur des régions 101 et 101' souhaitée (voir fig.5a). Les masques en laque photosensible M$_2$ et éventuellement M$_0$ s'il est en laque sont ensuite éliminés.

f/ Dépôt en surface du dispositif seulement muni du plot M$_1$ (voir fig.1a et 2d) d'une couche 103 d'épaisseur uniforme d'un diélectrique d'une seconde sorte. Ce diélectrique d'une seconde sorte sera favorablement le nitrure de silicium

($Si_3N_4$) sous une épaisseur au moins égale à celle du plot $M_1$, c'est-à-dire 200 à 600 nm.

g/ Cette étape consiste à obtenir la planarisation du dispositif au niveau de la surface supérieure du plot $M_1$ (fig.2e). A cet effet peut être utilisée une technique connue par exemple de la publication "Two-Layer Planarization Process" par A. Schitz et M. Pons dans J. Electrochem.Soc, Vol.133 N° 1, Jan.1986. On peut aussi utiliser une méthode plus simple en une couche. Cette technique consiste essentiellement à appliquer en surface d'un dispositif qui présente des irrégularités de surface telles que le plot $M_1$ une couche 2 épaisse d'un matériau tel qu'une laque photosensible (voir fig.2d). Cette couche 2 est soumise alors à une insolation à une énergie environ 3 fois supérieure à l'énergie d'insolation dans les conditions habituelles d'utilisation puis à une température de l'ordre de 150° à 200° qui permet de faire fluer la résine et donc d'obtenir pour la couche 2 une surface supérieure sensiblement plane. Cette couche est ensuite soumise à une gravure ionique réactive à l'aide de gaz $SF_6$ + $CHF_3$.

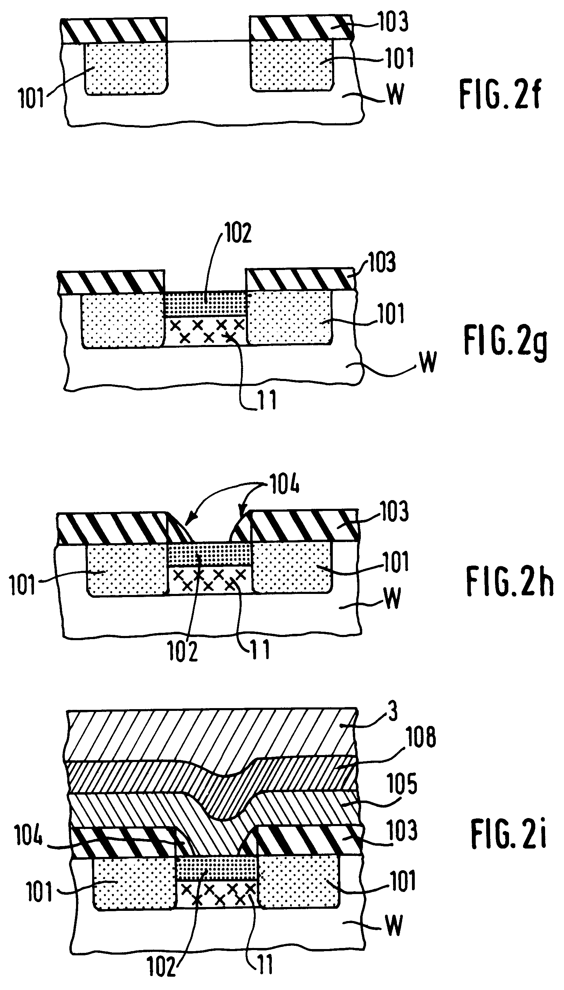

h/ Elimination du plot $M_1$ de façon à laisser une ouverture (20) de même surface dans la couche 103 de la seconde sorte de diélectrique. Dans le cas où le plot $M_1$ est en silice ($SiO_2$) et la couche 103 est en nitrure de silicium ($Si_3N_4$), cette élimination est obtenue par gravure ionique réactive sélective au moyen de gaz $CHF_3$ pur à pression élevée. Si le plot $M_1$ présente des flancs en pente, alors un meilleur résultat sera obtenu pour les mêmes matériaux avec un mélange de gaz $CHF_3$, $SF_6$ (voir fig.2f).

i/ Implantation dans l'ouverture 20 ainsi pratiquée dans la couche 103 de la seconde sorte de diélectrique, d'ions pour former la couche active 102 du premier type de conductivité (voir fig. 2g). Pour obtenir une couche active de type n dans l'arséniure de gallium, il peut être implanté des ions silicium (Si) à une concentration de l'ordre de $5.10^{16}$ à $5.10^{17}$ au $cm^3$.

$i_0$/ Une alternative à l'étape précédente consiste à l'implantation, avant de réaliser la couche active du premier type de conductivité du premier niveau de résistivité, d'une couche profonde 11 d'un second type de conductivité par exemple de type p. Pour obtenir une couche profonde de type p dans l'arséniure de gallium, il peut être implanté, avec une forte énergie, des ions béryllium (Be) ou magnésium (Mg) à une concentration de l'ordre de $10^{16}$ à $10^{17}$ au $cm^3$. Puis la couche active de type n est implantée comme décrit dans l'étape i/ et un recuit d'implantation est effectué (environ 800°C pendant environ 20 mn).

j/ Réalisation dans l'ouverture 20 de la couche de la seconde sorte de diélectrique 103, d'espaceurs 104 du même matériau diélectrique (voir fig.2h). Ces espaceurs 104 sont réalisés selon une technique décrite dans la publication intitulée "Edge-Defined Patterning of Hyperfine Refractory Metal Silicide MOS Structure" par SHINIJI OKAZAKI dans IEEE Transactions on Electron Devices, Vol.ED-28, N° 11, Nov.81, pp. 1364-1368. L'application de cette technique à la réalisation du présent dispositif est illustrée figures 3a et 3b. Une couche 104 du même matériau diélectrique que la couche 103, c'est-à-dire du diélectrique de la seconde sorte, est déposée de façon uniforme sur le dispositif et d'une épaisseur très précise $h_1$ choisie pour la dimension des espaceurs. L'épaisseur de la couche 104 est donc $h_1$, l'épaisseur totale des couches 103 et 104 est $h_2$. Il est ensuite pratiqué sur le dispositif une gravure ionique réactive telle qu'une épaisseur identique du matériau 104 est enlevée en chaque point. L'épaisseur de matériau 104 étant pratiquement égale à $h_2$ le long des flancs de l'ouverture 20 dans le couche 103 (voir figure 3a) après cette gravure il reste le long de ces flancs une portion de la couche 104 qui y est appuyée et qui a pour dimension latérale $h_1$ obtenue avec une précision $\simeq$ 1 % (voir figure 3b). Cette portion de couche 104 restante prend le nom "d'espaceur". L'espaceur a pour fonction de modifier la limite d'un masque par exemple. Ici les espaceurs 104 modifient l'ouverture 20 pratiquée dans la couche 103, (voir fig.2h) et sont prévus de manière à laisser subsister une ouverture égale à la longueur de grille L souhaitée pour le transistor. Typiquement une dimension de l'ordre de 0,5 $\mu$m. Cette méthode est extrêmement précise et répétitive contrairement à l'art antérieur. Si la couche 103 est en nitrure de silicium ($Si_3N_4$) la couche 104 est aussi en nitrure de silicium ($Si_3N_4$).

k/ dépôt sur le dispositif ainsi constitué d'une couche 105 du métal de grille, de l'ordre de 700 à 1200 nm puis d'une couche 108 d'un matériau choisi parmi le diélectrique de la première sorte ou un métal tel que le titane (Ti) d'épaisseur 200 à 500 nm, puis d'une couche 3 par exemple de laque photosensible ou tout matériau utilisable dans une technique de planarisation telle que précédemment décrite (voir fig.2i). Le métal de grille est avantageusement une multicouche de tungstène (W), tantale (Ta), Or (Au) respectivement d'épaisseur environ 200 nm, 100 nm, supérieure à 500 nm ou bien une multicouche de nitrure de tungstène (WN), nitrure de tantale (TaN), Or (Au) respectivement d'épaisseur environ 200 nm, 100 nm, supérieure à 500 nm, ou bien une multicouche de tungstène (W) et d'or (Au) d'épaisseur respectivement environ 200 nm, 100 nm, et supérieure à 500 nm.

l/ Planarisation du dispositif jusqu'au niveau supérieur de la couche métallique 105. Pour les matériaux indiqués précédemment la planarisation peut être effectuée par gravure RIE à l'aide de gaz $CHF_3 + SF_6$, ces gaz étant utilisés aussi bien si la couche 108 est en silice ($SiO_2$) que si elle est en titane (Ti) (voir fig.2j). A l'issue de cette planarisation, il reste en surface de la partie supérieure de la grille une région $M_3$ constituée du matériau diélectrique de la première sorte ($SiO_2$) ou bien constituée de titane (Ti). Cette région $M_3$ va servir de masque pour l'étape suivante.

m/ Gravure de la couche métallique de grille 105 autour du masque $M_3$. Si la couche métallique 105 est l'une des multicouches décrites précédemment, la couche supérieure est l'or (Au). La gravure de l'or est faite par faisceau d'ions de gaz neutre, qui produit une action purement mécanique. Les couches sous-jacentes, tantale (Ta) et tungstène (W) ou leur nitrure sont gravées par gravure ionique réactive à l'aide de gaz $CHF_3 + SF_6$. La gravure est poursuivie jusqu'au niveau supérieur de la couche du matériau diélectrique de la seconde sorte 103. La grille présente alors deux parties : une partie inférieure 15, sous le niveau de la couche 103, partie inférieure qui présente grossièrement la forme d'un trapézoïde dont la petite base est en contact avec la couche active 102 ; et une partie supérieure 51 qui forme un plot couvert par le masque $M_3$. A ce stade si le masque $M_3$ est en silice ($SiO_2$) il peut être éliminé.

n/ Réalisation par la technique précédemment décrite d'espaceurs 106 en matériau diélectrique de la première sorte ($SiO_2$). Ces espaceurs 106 forment une région périphérique débordant la partie supérieure du métal 105 et surplombant une partie de la couche 103 du matériau diélectrique de la seconde sorte ($Si_3N_4$). Le bord extérieur de ces espaceurs 106 est prévu pour définir le bord des contacts de source et drain (voir figure 2f).

C'est parce que le procédé selon l'invention permet d'obtenir une grille épaisse, que l'on tire l'avantage de réaliser les espaceurs 106 qui eux-mêmes vont permettre l'autoalignement des contacts ohmiques.

o/ Gravure de la couche 103 du diélectrique de la seconde sorte par RIE. Si la couche 103 est en nitrure de silicium cette gravure est pratiquée à l'aide de gaz $CHF_3 + SF_6$ (voir fig.2m). A l'issue de cette opération, la grille est constituée de la partie métallique 105 dont la surface en contact avec le semiconducteur est la petite base du trapézoïde, de la partie périphérique 106 qui surplombe les parties restantes des couches 103, 104 en diélectrique de la seconde sorte et éventuellement du masque $M_3$. La partie périphérique 106 est en diélectrique de la première sorte, mais le masque $M_3$ peut être soit du même diélectrique soit en titane (Ti). La couche 103 peut être légèrement sous-gravée par rapport aux bords extérieurs de la région périphérique 106. Ces bords extérieurs vont servir à délimiter les couches métalliques de contact de grille et drain. Cependant si le masque $M_3$ est en silice et qu'il n'a pas encore été éliminé, il est conservé pour l'étape suivante.

p/ Réalisation des contacts ohmiques 107 de source et drain dans l'ouverture laissée entre le masque $M_0$ et le masque constitué par la grille dans l'état de l'étape o). Le métal de la couche 107 sera constitué favorablement par l'évaporation sous vide ou par pulvérisation cathodique d'un alliage or-germanium puis l'évaporation ou pulvérisation d'une couche de Nickel. Puis formation de l'alliage or-germanium-Nickel à environ 450°C. L'épaisseur des couches de contact ohmique sera favorablement de 0,5 à 1 $\mu$m. La grille telle que constituée à cette étape supporte très bien une telle température. Cette étape est favorable au cas où le masque $M_3$ est en titane (Ti). En effet le métal de la couche 107 se dépose aussi sur la grille. Mais cette dernière étant entièrement métallique à l'exception des régions périphériques 106, la surépaisseur amenée par le métal 107 et sur une grande surface due aux régions 107 est très favorable à la diminution de la résistivité du contact de grille.

Si le masque $M_3$ n'est pas en titane (Ti), alors l'étape p'), qui est une alternative à l'étape p) doit être entreprise après l'étape o).

p') réalisation des contacts ohmiques 107 de source et drain dans l'ouverture laissée entre le masque $M_0$ et le masque constitué par la grille dans l'état de l'étape o). Le métal de la couche 107 sera également, comme dans l'étape p), constitué favorablement d'un alliage or-germanium couvert d'une couche de nickel avec formation de l'alliage or-germanium-nickel à 450°C. L'épaisseur de cette couche sera encore de l'ordre de 0,5 à 1 $\mu$m.

Mais si le masque $M_3$ est en diélectrique il devra obligatoirement être éliminé à l'issu du dépôt de la couche 107 afin de retrouver une surface supérieure métallique pour la grille dans le but de réaliser les liaisons et connexions ultérieures.

Comme le masque $M_3$ est constitué du même diélectrique que les régions périphériques 106, l'élimination du masque $M_3$ est dans ce cas subordonnée à l'élimination des régions périphériques 106.

Si les régions $M_3$ et 106 sont constituées de silice, elles sont éliminées par exemple par voie humide au moyen de solutions tamponnées à base d'acide fluorhydrique.

La seule élimination des régions périphériques 106 peut aussi être entreprise, dans une autre variante du procédé, même si le masque $M_3$ est en titane (Ti).

L'une de ces deux variantes doit obligatoirement être utilisée pour réaliser, au lieu du transistor monogrille décrit précédemment, un transistor à plusieurs doigts de grille.

La réalisation d'un tel transistor est illustrée par les figures 4a et 4b. Tel que montré sur ces figures, en coupe, un transistor à plusieurs doigts de grille est réalisé sur un substrat W. Il comporte autant de couches actives 102 que de doigts de grille. Les couches actives 102 sont séparées par des régions 101″ du même type de conductivité que les régions de source et drain 101 et 101′ qui sont disposées de part et d'autre des doigts de grille extrême.

La réalisation d'un tel transistor repose sur le choix de la dimension notée $h_1$ de chaque espaceur 104 et 106 mis en oeuvre dans le procédé. En effet, selon l'invention, le dispositif obtenu à l'issu de l'étape n) doit être tel que les espaceurs 106, entre deux doigts de grille contigüs, soient en contact pour éviter dans l'étape ultérieure la gravure des couches 103, 104 entre deux doigts de grille. Ceci est obtenu en prévoyant que la distance entre deux doigts de grille est égale à 2 fois la largeur $h_1$ de l'espaceur 104, ajoutée à 2 fois la largeur $h_1$ de l'espaceur 106.

En particulier, pour réaliser plusieurs doigts de grille, il faudra lors de l'étape h) former autant d'ouvertures 20 que de doigts de grille pour pouvoir réaliser les couches actives en conséquence. Et les espaceurs 104 seront appliqués à chacune de ces ouvertures 20.

La figure 4a montre que les espaceurs 106 servent uniquement ici au procédé d'autoalignement. Ils sont éliminés pour obtenir le transistor multi-grille tel que représenté en coupe dans sa forme finale, sur la figure 4b. Cependant le sommet des contacts de grille du transistor multigrille peut conserver le masque $M_3$ si ce dernier est en titane (Ti) comme sur la figure 5b.

Pour obtenir le transistor multigrille selon l'invention, il suffit donc de reprendre les étapes du procédé proposé pour le transistor monogrille, en apportant lors de ces étapes les légères modifications décrites ci-dessus.

Dans l'un comme dans l'autre mode opératoire, les opérations peuvent se succéder sans sortir la plaquette substrat W du bâti. En effet, d'une façon générale les matériaux ont été choisis pour permettre l'enchaînement continu des opérations. Ainsi la silice ($SiO_2$) subit la gravure RIE avec le gaz $CHF_3$ ou $CF_4$ pur à pression élevée, et tous les autres matériaux, sauf l'or qui subit une gravure mécanique, peuvent être gravés par RIE avec le mélange des gaz $CHF_3$ + $SF_6$.

Enfin entre l'étape h/ et l'étape i/ ou $i_0$/ peut être introduite une étape :

$h_0$/ Formation d'une dépression dans la couche active 102 pour délimiter une région dans laquelle l'épaisseur du canal est moindre. Cette dépression est obtenue par exemple par gravure chimique de la couche active 102 dans la région délimitée par les espaceurs 104 ou moins favorablement dans l'état actuel de la technique par RIE. Si le substrat est en arséniure de gallium la gravure est faite de préférence à l'aide de solutions comprenant l'acide citrique, eau oxygénée et eau par exemple.

Les variantes décrites en $d_0$, $i_0$, $h_0$ peuvent aussi être mises en oeuvre pour réaliser le transistor multigrilles.

## Revendications

1. Procédé de réalisation d'un dispositif semiconducteur du type transistor à effet de champ comprenant, formée en surface d'un substrat semiconducteur (W), une couche (102) d'un premier type de conductivité d'un premier niveau de résistivité dite couche active sur laquelle est réalisée une électrode de grille (G) de type Schottky, présentant dans sa partie inférieure (15) la forme générale d'un trapézoïde dont la petite base est en contact avec la couche active, comprenant ensuite de part et d'autre de la couche active deux régions (101, 101') du même type de conductivité d'un second niveau de résistivité constituant les régions de source et de drain, régions dont les bords adjacents à la couche active sont alignés avec les arêtes de la grande base ou base supérieure du trapézoïde, et comprenant en outre des électrodes (107) de source et de drain du type contact ohmique réalisées en surface des régions du premier type de conductivité d'un second niveau de résistivité, ce procédé comprenant au moins les étapes de :

   a/ formation d'un substrat W d'un matériau semiconducteur monocristallin, présentant une face orientée parallement à un plan cristallographique ;

   b/ réalisation en surface de ce substrat d'une couche en un matériau diélectrique (1) d'une première sorte ;

   c/ réalisation en surface de la couche précédente d'un masque $M_2$ délimitant la grande base du trapézoïde constituant la partie dite inférieure de l'électrode de grille ;

d/ gravure autour du masque $M_2$, de la couche diélectrique de la première sorte, par gravure ionique réactive (RIE) pour obtenir un plot $M_1$ en diélectrique de la première sorte surmonté du masque $M_2$ ;

e/ implantation autour du plot $M_1$ servant de masque et dans l'ouverture d'un masque $M_0$ délimitant la périphérie du transistor, d'ions aptes à former les régions de source et de drain (101, 101') du premier type de conductivité du second niveau de résistivité, puis élimination des masques $M_0$ et $M_2$ ;

f/ dépôt en surface du dispositif seulement muni du plot $M_1$ d'une couche (103) d'épaisseur uniforme au moins égale à celle du plot $M_1$, en matériau diélectrique d'une seconde sorte ;

g/ planarisation par une méthode connue en soi, du dispositif au niveau de la surface supérieure du plot $M_1$ ;

h/ élimination par gravure ionique réactive sélective du plot $M_1$, de façon à former une ouverture de même surface dans la couche diélectrique de la seconde sorte, mettant à nu le substrat W ;

i/ implantation dans cette ouverture en outre délimitée par le masque $M_0$, d'ions aptes à former la couche active (102) du premier type de conductivité du premier niveau de résistivité, recuit d'implantation, et élimination du masque $M_0$ ;

j/ réalisation par une méthode connue en soi d'espaceurs (104) appuyés sur les flancs de l'ouverture pratiquée dans la couche du diélectrique de la seconde sorte, ces espaceurs étant du diélectrique de la seconde sorte, et leur épaisseur étant prévue pour réduire les dimensions de l'ouverture aux dimensions voulues pour la longueur de grille L du transistor et pour définir en même temps la distance qui sépare l'électrode de grille des régions de source et drain ;

k/ dépôt d'une couche (105) du métal de grille d'épaisseur supérieure à celle de la couche du diélectrique de la seconde sorte, puis d'une couche (108) choisie parmi le diélectrique de la première sorte ou le titane (Ti), ces couches étant d'épaisseur uniforme ;

l/ planarisation par une méthode connue en soi du dispositif jusqu'au niveau supérieur de la couche du métal de grille, de telle sorte que subsiste aussi, en surface de la dépression formée dans la couche métallique de grille au-dessus de l'ouverture de la couche diélectrique de la seconde sorte, une couche du diélectrique de la première sorte ou de titane constituant un masque $M_3$ ;

m/ gravure autour du masque $M_3$ de la couche métallique de grille par une méthode choisie parmi la gravure ionique réactive sélective RIE ou la gravure par faisceau d'ions de gaz neutre, cette méthode étant choisie selon le métal constituant cette couche, jusqu'au niveau supérieur de la couche du matériau diélectrique de la seconde sorte, pour former la région centrale métallique de la partie dite supérieure de la grille ;

n/ réalisation par une technique connue en soi, d'espaceurs (106) appuyés sur les flancs de la couche métallique de grille, pour former une région diélectrique périphérique à la partie métallique supérieure de la grille, surplombant la couche diélectrique de la seconde sorte, ces espaceurs étant en diélectrique de la première sorte, et leur épaisseur étant prévue pour définir la distance qui sépare les électrodes de source et drain de la couche active, en sorte que la distance qui sépare l'électrode de grille des électrodes de source et drain égale la somme des épaisseurs des espaceurs mis en oeuvre dans le procédé ;

o/ gravure de la couche du diélectrique de la seconde sorte par gravure ionique réactive sélective, autour du plot formé par la partie supérieure de grille couverte du masque $M_3$ et des espaceurs en diélectrique de la première sorte, jusqu'au niveau supérieur du substrat, cette gravure pouvant éventuellement être légèrement prolongée latéralement sous les espaceurs.

2. Procédé de réalisation selon la revendication 1, caractérisé en ce qu'il comprend en outre l'étape :

p/ dépôt en surface du dispositif précédent, le masque $M_3$ étant en titane (Ti), dans l'ouverture du masque $M_0$ définissant la périphérie du transistor, d'une couche (107) d'un métal apte à former un contact ohmique avec le matériau semiconducteur pour constituer les contacts de source S et drain D et élimination du masque $M_0$.

3. Procédé de réalisation selon la revendication 1, caractérisé en ce qu'il comprend en outre l'étape :

p'/ dépôt en surface du dispositif précédent, le masque $M_3$ étant en titane (Ti) ou bien en diélectrique da la première sorte, dans l'ouverture du masque $M_0$ définissant la périphérie du transistor, d'une couche (107) d'un métal apte à former un contact ohmique avec le matériau semiconducteur, et élimination du masque $M_0$ et des régions diélectriques de la première sorte, entraînant par un procédé connu en soi de LIFT-OFF les couches métalliques déposées sur ces couches diélectriques.

4. Procédé de réalisation d'un dispositif semiconducteur du type transistor à effet de champ comprenant formée en surface d'un substrat semiconducteur (W) des couches (102) d'un premier type de conductivité d'un premier niveau de résistivité dites couches actives sur lesquelles sont réalisées des électrodes de grille G de type Schottky présentant dans leur partie dite inférieure (15) la forme générale d'un trapézoïde dont la petite base est en contact avec une couche active, comprenant ensuite entre chaque couche active une région (101") d'un premier type de conductivité d'un second niveau de résistivité, et, de part et d'autre des couches actives extrêmes, deux régions (101, 101') du premier type de conductivité d'un second niveau de résistivité, ce procédé comprenant au moins les étapes de :

a'/ formation d'un substrat W d'un matériau semiconducteur monocristallin, présentant une face orientée parallement à un plan cristallographique ;

b'/ réalisation en surface de ce substrat d'une couche (1) en un matériau diélectrique d'une première sorte ;

c'/ réalisation en surface de la couche précédente d'un masque $M_2$ délimitant plusieurs doigts correspondant à la grande base de chaque trapézoïde constituant la partie dite inférieure de chaque électrode de grille ;

d'/ gravure autour du masque $M_2$, de la couche diélectrique de la première sorte, par gravure ionique réactive (RIE) pour obtenir un plot $M_1$ en diélectrique de la première sorte surmonté du masque $M_2$ et de même forme que ce dernier ;

e'/ implantation autour du plot $M_1$ servant de masque et dans l'ouverture d'un masque $M_0$ délimitant la périphérie du transistor, d'ions aptes à former les régions (101, 101', 101") du premier type de conductivité du second niveau de résistivité, puis élimination des masques $M_0$ et $M_2$ ;

f'/ dépôt en surface du dispositif seulement muni du plot $M_1$ d'une couche (103) d'épaisseur uniforme au moins égale à celle du plot $M_1$, en matériau diélectrique d'une seconde sorte ;

g'/ planarisation par une méthode connue en soi, du dispositif au niveau de la surface supérieure du plot $M_1$ ;

h'/ élimination par gravure ionique réactive sélective du plot $M_1$, de façon à former des ouvertures de même formes et surface dans la couche diélectrique de la seconde sorte, mettant à nu le substrat W ;

i'/ implantation dans ces ouvertures en outre délimitées par le masque $M_0$, d'ions aptes à former les couches actives (102) du premier type de conductivité du premier niveau de résistivité, recuit d'implantation, et élimination du masque $M_0$ ;

j'/ réalisation par une méthode connue en soi d'espaceurs (104) appuyés sur les flancs des ouvertures pratiquées dans la couche du diélectrique de la seconde sorte, ces espaceurs étant du diélectrique de la seconde sorte, et leur épaisseur étant prévue pour réduire les dimensions des ouvertures aux dimensions voulues pour la longueur des doigts de grille L du transistor et pour définir en même temps la distance qui sépare les doigts de grille extrêmes des régions de source et drain ;

k'/ dépôt d'une couche (105) du métal de grille d'épaisseur supérieure à celle de la couche du diélectrique de la seconde sorte, puis d'une couche (108) choisie parmi le diélectrique de la première sorte ou le titane (Ti), ces couches étant d'épaisseur uniforme ;

l'/ planarisation par une méthode connue en soi du dispositif jusqu'au niveau supérieur de la couche du métal de grille, de telle sorte que subsiste aussi, en surface de la dépression formée dans la couche métallique de grille au-dessus de l'ouverture de la couche diélectrique de la seconde sorte, une couche du diélectrique de la première sorte ou de titane constituant un masque $M_3$ ;

m'/ gravure autour du masque $M_3$ de la couche métallique de grille par une méthode choisie parmi la gravure ionique réactive RIE sélective ou la gravure par faisceau d'ions de gaz neutre, cette méthode étant choisie selon le métal constituant cette couche, jusqu'au niveau supérieur de la couche du matériau diélectrique de la seconde sorte, pour former la région centrale métallique de la partie dite supérieure des doigts de grille ;

n'/ réalisation par une technique connue en soi, d'espaceurs (106) appuyés sur les flancs de la couche métallique de la partie métallique supérieure des doigts de grille, surplombant la couche diélectrique de la seconde sorte, ces espaceurs étant en diélectrique de la première sorte, et leur épaisseur étant prévue pour définir la distance qui sépare les électrodes de source et drain des zones actives adjacentes, en sorte que la distance qui sépare l'électrode de source et un doigt de grille ou un doigt de grille et l'électrode de drain égale la somme des épaisseurs des espaceurs mis en oeuvre dans le procédé et leur épaisseur étant prévue d'autre part pour que les espaceurs de la partie supérieure de grille de deux doigts de grille adjacents soient en contact en sorte que la distance entre deux doigts de grille adjacent égale la double somme des épaisseurs des espaceurs mis en oeuvre dans le procédé ;

o'/ gravure de la couche du diélectrique de la seconde sorte par gravure ionique réactive sélective, autour du plot formé par la partie supérieure de grille couverte du masque $M_3$ et des espaceurs en diélectrique de la première sorte, jusqu'au niveau supérieur du substrat ;

p'/ dépôt en surface du dispositif précédent, le masque $M_3$ étant en titane (Ti) ou bien en diélectrique de la première sorte, dans l'ouverture du masque $M_0$ définissant la périphérie du transistor, d'une couche (107) d'un métal apte à former un contact ohmique avec le matériau semiconducteur pour former les contacts de source S et drain D puis élimination du masque $M_0$ et des régions diélectriques de la première sorte et éventuellement $M_3$, entraînant par un procédé connu en soi de LIFT-OFF les couches métalliques déposées sur ces couches diélectriques.

5. Procédé de réalisation selon l'une des revendications 1 à 4, caractérisé en ce qu'entre l'étape j) et l'étape k) ou l'étape j') et k') est mis en oeuvre une étape supplémentaire :

j₀/ formation par une méthode choisie entre la gravure ionique réactive sélective et la gravure chimique d'une dépression dans la (ou les) couche(s) active(s) pour diminuer localement son (leur) épaisseur.

6. Procédé de réalisation selon l'une des revendications 1 à 5, caractérisé en ce que les conditions de la gravure ionique sélective sont choisies de telle sorte que le plot $M_1$ constitue un trapézoïde dont la grande base est en contact avec le matériau semiconducteur.

7. Procédé de réalisation selon l'une des revendications 1 à 6, caractérisé en ce qu'entre l'étape h) et l'étape i) ou l'étape h' et l'étape i' est mise en oeuvre une étape supplémentaire :

h₀/ implantation dans cette ouverture en outre délimitée par le masque $M_0$, et avec une grande énergie pour former une couche (11) profonde, d'ions aptes à former la couche du second type de conductivité.

8. Procédé de réalisation selon l'une des revendications 1 à 7, caractérisé en ce que le substrat étant en arséniure de gallium (GaAs) semi-isolant, les ions pour obtenir les régions du premier type de conductivité et second niveau de résistivité $n^+$ sont du silicium à une concentration d'environ $10^{17}$ à $10^{18}$ au $cm^3$, les ions pour obtenir la (les) couche(s) active(s) du premier type de conductivité et premier niveau de résistivité n sont du silicium à la concentration d'environ $5.10^{16}$ à $5.10^{17}$ au $cm^3$, et les ions pour obtenir la couche du second type de conductivité p lorsqu'elle existe sont le magnésium (Mg) ou le béryllium (Be) à une concentration de $10^{16}$ à $10^{17}$ au $cm^3$, et en ce que le recuit d'implantation est d'environ 800°C pendant 20 min.

9. Procédé de réalisation selon l'une des revendications 1 à 8, caractérisé en ce que le métal formant l'électrode de grille est une superposition de couches métalliques choisie parmi :

- une superposition de tungstène (W), tantale (Ta) et Or (Au) d'épaisseurs respectives environ 200 nm, environ 100nm, et supérieure à 500 nm :

- une superposition de nitrure de tungstène (WN), nitrure de tantale (TaN) et Or (Au) d'épaisseurs respectives environ 200 nm, environ 100 nm et supérieure à 500 nm ;

- une superposition de tungstène (W) et d'Or (Au) d'épaisseurs respectives environ 200 nm et supérieure à 500 nm et en ce que cette couche multiple de grille est réalisée par une méthode choisie entre l'évaporation sous vide et la pulvérisation cathodique.

10. Procédé de réalisation selon l'une des revendications 1 à 9, caractérisé en ce que pour former les contacts ohmiques de source et drain une couche d'alliage or-germanium (Au-Ge) est d'abord déposée par une méthode choisie entre l'évaporation sous vide et la pulvérisation cathodique, puis en ce qu'une couche de nickel (Ni) est déposée par la même méthode, et en ce que le dispositif est porté à une température de l'ordre de 450°C pour former l'alliage or-germanium-nickel (Au-Ge-Ni), la couche d'alliage obtenue présentant une épaisseur d'environ 0,5 à 1 $\mu$m.

11. Procédé selon l'une des revendications précédentes caractérisé en ce que le diélectrique de la première sorte est la silice ($SiO_2$) et le diélectrique de la seconde sorte est le nitrure ($Si_3N_4$).

12. Procédé de réalisation selon l'une des revendications 1 à 11, caractérisé en ce que la mise en oeuvre des gravures de toutes couches nécessaires au procédé, à l'exception des couches d'or et de silice est faite par gravure ionique réactive à l'aide de gaz $CHF_3$ + $SF_6$, en ce que la mise en oeuvre de la gravure des couches de silice est faite par gravure ionique réactive à l'aide de ces mêmes gaz pour obtenir des flancs de gravure inclinés par rapport au substrat, ou par gravure ionique réactive à l'aide de gaz $CH_3$ ou $CF_4$ purs à pression élevée pour obtenir des flancs de gravure perpendiculaires au substrat, et en ce que la gravure de la couche d'or lorsqu'elle existe est faite par gravure par faisceau d'ions de gaz neutre.

13. Dispositif semiconducteur du type transistor à effet de champ obtenu selon un procédé de réalisation conforme à celui de la revendication 1, caractérisé en ce que l'électrode de grille G comporte une partie supérieure (51) surmontant la grande base du trapézoïde, cette partie supérieure présentant une région centrale métallique (105) et une zone périphérique (106) en une première de sorte de diélectrique, en ce que la zone périphérique déborde la surface de la grande base du trapézoïde, en ce que les bords des électrodes de source S et de drain D les plus près de la grille G sont autoalignés avec les bords externes de la zone périphérique de la grille, et en ce que cette zone périphérique de grille surplombe une couche (103) d'une seconde sorte de diélectrique disposée dans l'intervalle entre les contacts de grille et de source d'une part et les contacts de grille et de drain d'autre part.

14. Dispositif selon la revendication 13, obtenu selon le procédé conforme à celui de la revendication 2, caractérisé en ce que la surface supérieure de la grille est couverte d'une couche métallique (107) identique à celle qui constitue les électrodes de source et drain.

15. Dispositif selon la revendication 13, obtenu selon le procédé conforme à celui de la revendication 3, caractérisé en ce que la partie supérieure de grille est entièrement métallique.

16. Dispositif semiconducteur du type transistor à effet de champ obtenu selon le procédé conforme à celui de la revendication 4, caractérisé en ce qu'il comprend plusieurs doigts de grille adjacents dont les parties supérieures sont entièrement métalliques, et en ce que les différentes électrodes sont isolées entre elles par une couche (103, 104) du diélectrique de la seconde sorte.

17. Dispositif selon l'une des revendications 13 à 16, caractérisé en ce que chaque couche active (102) comporte en surface une dépression formant une zone centrale dans laquelle son épaisseur est réduite, en ce que chaque électrode de grille est réalisée dans cette zone, la petite base du trapézoïde en contact avec le fond de la dépression, pour former un transistor dit à canal creusé.

18. Dispositif selon l'une des revendications 13 à 17, caractérisé en ce que l'épaisseur des régions de source et drain du premier type de conductivité du second niveau de résistivité est croissante à mesure que l'on s'éloigne de la couche active pour atteindre le maximum d'épaisseur sous les électrodes de source et drain.

19. Dispositif selon l'une des revendications 13 à 18, caractérisé en ce que sous la couche active (les couches actives) s'étend une région (11) d'un second type de conductivité.

20. Dispositif selon l'une des revendications 13 à 19, caractérisé en ce que le substrat est en arséniure de gallium (GaAs) semi-isolant, la région du premier type de conductivité du premier niveau de résistivité est en arséniure de gallium de type n, les régions du premier type de conductivité du second niveau de résistivité sont en arséniure de gallium de type $n^+$, et lorsqu'elle existe la région du second type de conductivité est en arséniure de gallium de type p.

21. Dispositif selon l'une des revendications 13 à 20, caractérisé en ce que le métal formant l'électrode de grille est une superposition de couches métalliques choisie parmi :
    - une superposition de tungstène (W), tantale (Ta) et Or (Au) d'épaisseurs respectives environ 200 nm, environ 100nm, et supérieure à 500 nm :
    - une superposition de nitrure de tungstène (WN), nitrure de tantale (TaN) et Or (Au) d'épaisseurs respectives environ 200 nm, environ 100 nm et supérieure à 500 nm ;

- une superposition de tungstène (W) et d'Or (Au) d'épaisseurs respectives environ 200 nm et supérieure à 500 nm et en ce que cette couche multiple de grille est réalisée par une méthode choisie entre l'évaporation sous vide et la pulvérisation cathodique.

22. Dispositif selon l'une des revendications 13 à 21, caractérisé en ce que le métal formant les électrodes de source et drain est un alliage d'or-germanium-Nickel (Au-Ge-Ni).

23. Dispositif selon l'une des revendications précédentes, caractérisé en ce que la première sorte de diélectrique est la silice ($SiO_2$), et la seconde sorte est le nitrure de silicium ($Si_3N_4$).

**Claims**

1. A process for making a field effect transistor type semiconductor device comprising at the surface of a semiconductor substrate (W) a layer (102) of a first conductivity type at a first resistivity level, which is designated as active layer and on which a gate electrode (G) of the Schottky type is formed having in its lower part (15) the general shape of a trapezoid whose minor base is in contact with the active layer, further comprising on either side of the active layer two regions (101, 101') of the same conductivity type at a second resistivity level constituting the source and drain regions, whose edges adjacent to the active layer are aligned with the edges of the major base or upper base of the trapezoid, and moreover comprising source and drain electrodes (107) of the ohmic contact type formed at the surface of the regions of the first conductivity type at a second resistivity level, this method comprising at least the steps of:

a/ forming a substrate W of a mono-crystalline semiconductor material having a surface orientated parallel to a crystallographic plane;

b/ forming at the surface of said substrate a layer of a dielectric material (1) of a first kind;

c/ forming at the surface of the preceding layer a mask $M_2$ defining the major base of the trapezoid constituting the so-called lower part of the gate electrodes;

d/ etching around the mask $M_2$ the dielectric layer of the first kind by reactive ion etching (RIE) to obtain a contact $M_1$ of dielectric material of the first kind, on which mask $M_2$ is disposed;

e/ implanting around the contact $M_1$ serving as a mask and in the opening of a mask $M_0$ defining the periphery of the transistor ions suitable for forming the source and drain regions (101, 101') of the first conductivity type at the second resistivity level, and then eliminating the masks $M_0$ and $M_2$;

f/ depositing at the surface of the device only provided with the contact $M_1$ a layer (103) of dielectric material of a second kind having a uniform thickness at least dual to that of the contact $M_1$,

g/ planarizing, by a method known *per se,* the device at the level of the upper surface of the contact $M_1$;

h/ eliminating the contact $M_1$ by selective reactive ion etching so as to form an opening of the same surface area in the dielectric layer of the second kind, exposing the substrate $W_1$;

i/ implanting in this opening moreover defined by the mask $M_0$ ions suitable for forming the active layer (102) of the first conductivity type of said first resistivity level, implantation annealing, and eliminating the mask $M_0$;

j/ forming by a method known *per se,* spacers bearing on the edges of the opening provided in the layer of the dielectric of the second kind, said spacers being made of the dielectric of the second kind and their thickness being so provided as to reduce the dimensions of the opening to the dimensions desired for the length L of the gate of the transistor and to define at the same time the distance between the gate electrode and the source and drain regions,

k/ depositing a layer (105) of gate metal having a thickness exceeding that of the layer of the dielectric of the second kind and then a layer (108) chosen from the dielectric of the first kind and titanium (Ti), these layers having a uniform thickness;

l/ planarizing by a method known *per se,* the device down to the upper level of the gate metal layer, in such a manner that at the surface of the depression formed in the gate metal layer above the opening of the layer of the dielectric of the second kind also a layer subsists of the dielectric of the first kind or of titanium constituting a mask $M_3$;

m/ etching around the mask $M_3$ the metallic gate layer by a method chosen from reactive selective ion etching (RIE) and etching by a beam of ions of a neutral gas, this method being chosen in accordance with the metal constituting said metal gate layer, down to the upper level of the layer of the dielectric material of the second kind, to form the metallic central region of the upper part of the gate;

n/ forming, by a technique known *per se,* spacers (106) bearing on the edges of the metallic gate layer to form a peripheral dielectric region at the upper metallic part of the gate at right angles to the dielectric layer of the second kind, these spacers consisting of a dielectric material of the first kind and their thickness being so provided as to define the distance between the source and drain electrodes and the active layer, so that the distance between the gate electrode and the source and drain electrodes equals the sum of the thicknesses of the spacers used in the method,

o/ etching the layer of the dielectric material of the second kind by reactive selective ion etching around the contact formed by the upper part of the gate covered by the mask $M_3$ and the spacers of the dielectric material of the first kind down to the upper level of the substrate, which etching treatment may be slightly prolonged laterally under the spacers.

2. A manufacturing method as claimed in Claim 1, characterized in that it moreover comprises the step of:

p/ depositing at the surface of the preceding device, the mask $M_3$ consisting of titanium (Ti), in the opening of the mask $M_0$ defining the periphery of the transistor a layer (107) of a metal suitable for forming an ohmic contact with the semiconductor material to form the source S and drain D contacts, and eliminating the mask $M_0$.

3. A manufacturing method as claimed in Claim 1, characterized in that it moreover comprises the step of:

p'/ depositing at the surface of the preceding device, the mask $M_3$ consisting of titanium (Ti) or of the dielectric material of the first kind, in the opening of the mask $M_0$ defining the periphery of the transistor a layer (107) of a metal suitable for forming an ohmic contact with the semiconductor material, and eliminating the mask $M_0$ and the dielectric regions of the first kind taking along by a "lift-off" method known *per se* the metallic layer deposited on these dielectric layers.

4. A method of manufacturing a semiconductor device of the field effect transistor type comprising at the surface of a semiconductor substrate (W) layers (102) of a first conductivity type and of a first resistivity level, which are designated as active layers and on which are formed gate electrodes (G) of the Schottky type having in their lower part (15) the general form of a trapezoid whose minor base is in contact with an active layer, then comprising between each two successive active layers a region (101") of a first conductivity type at a second resistivity level and on either side of the outer active layers two regions (101, 101') of the first conductivity type at a second resistivity level,

this method comprising at least the following steps:

a'/ forming a substrate W of a monocrystalline semiconductor material having a surface orientated parallel to a crystallographic plane;

b'/ forming at the surface of this substrate a layer (1) of a dielectric material of a first kind;

c'/ forming at the surface of the preceding layer a mask $M_2$ defining several fingers corresponding to the major base of each trapezoid constituting the lower part of each gate electrode;

d'/ etching around the mask $M_2$ the dielectric layer of the first kind by reactive ion etching (RIE) to obtain a contact $M_1$ of dielectric material of the first kind, on which the mask $M_2$ is disposed and which has the same shape as the latter;

e'/ implanting around the contact $M_1$ serving as a mask and in the opening of a mask $M_0$ defining the periphery of the transistor ions suitable for forming the regions of the first conductivity type at the second resistivity level, and then eliminating the masks $M_0$ and $M_2$;

f'/ depositing at the surface of the device only provided with the contact $M_1$ a layer (103) of dielectric material of a second kind, having a uniform thickness at least equal to that of the contact $m_1$;

g'/ planarizing, by a method known *per se,* the device at the level of the upper surface of the contact $M_1$;

h'/ eliminating by selective reactive ion etching the contact $M_1$ so as to form openings of the same shape and surface area in the dielectric layer of the second kind, exposing the substrate W;

i'/ implanting in these openings moreover defined by the mask $M_0$ ions suitable for

forming the active layers (102) of the first conductivity type at the first resistivity level, implantation annealing and eliminating the mask $M_0$;

j'/ forming, by a method known *per se,* spacers (104) bearing on the edges of the openings provided in the layer of the dielectric material of the second kind, these spacers being made of the dielectric material of the second kind and their thickness being so provided as to reduce the dimensions of the openings to the dimensions desired for the length L of the gate fingers of the transistor and to define at the same time the distance between the outer gate fingers and the source and drain regions,

k'/ depositing a layer (105) of gate metal having a thickness exceeding that of the dielectric layer of the second kind and then a layer (108) chosen from the dielectric material of the first kind and titanium (Ti), these layers having a uniform thickness,

l'/ planarizing, by a method known *per se,* the device down to the upper level of the gate metal layer in such a manner that at the surface of the depression formed in the gate metal layer above the opening of the dielectric layer of the second kind also a layer subsists of the dielectric material of the first kind or of titanium constituting a mask $M_3$;

m'/ etching the gate metal layer around the mask $M_3$ by a method chosen from selective reactive ion etching RIE and etching by a beam of ions of a neutral gas, this method being chosen in accordance with the metal constituting this layer, down to the upper level of the layer of the dielectric material of the second kind, to form the metallic central region of the so-called upper part of the gate fingers;

n'/ forming, by a technique known *per se,* spacers (106) bearing on the edges of the metallic layer of the upper part of the gate fingers at right angles to the dielectric layer of the second kind, these spacers being made of a dielectric material of the first kind and their thickness being provided so as to define the distance between the source and drain electrodes and the adjacent active zones, so that the distance between the source electrode and a gate finger and a gate finger and the drain electrode equals the sum of the thicknesses of the spacers used in the method, and their thickness being provided on the other hand in order that the spacers of the upper gate part of two adjacent gate fingers are in contact, so that the distance between two adjacent gate fingers equals double the sum of the thicknesses of the spacers used in the method;

o'/ etching the layer of the dielectric material of the second kind by selective reactive ion etching around the contact formed by the upper gate part covered by the mask $M_3$ and the spacers of a dielectric material of the first kind down to the upper level of the substrate;

p'/ depositing at the surface of the preceding device, the mask $M_3$ being made of titanium (Ti) or of a dielectric material of the first kind, in the opening of the mask $M_0$ defining the periphery of the transistor a layer (107) of a metal suitable for forming an ohmic contact with the semiconductor material to form the source S and drain D contacts, and then eliminating the mask $M_0$ and the dielectric regions of the first kind and, as the case may be, $M_3$ taking along by a lift-off method known *per se* the metallic layers deposited on these dielectric layers.

5. A manufacturing method as claimed in any one of Claims 1 to 4, characterized in that between the step j/ and the step k/, or the step j'/ and the step k'/ a supplementary step is introduced of:

j_0/ forming a depression in the active layer(s) by a method chosen from selective reactive ion etching and chemical etching for reducing locally its (their) thickness.

6. A manufacturing method as claimed in any one of Claims 1 to 5, characterized in that the conditions of selective reactive ion etching are chosen so that the contact $M_1$ constitutes a trapezoid, whose major base is in contact with the semiconductor material.

7. A manufacturing method as claimed in any one of Claims 1 to 6, characterized in that between the step h/ and the step i/, or the step h'/ and the step i'/ a supplementary step is introduced of:

h_0/ implanting ions suitable for forming the layer of the second conductivity type in this opening moreover defined by the mask $M_0$ with a high energy to form a deep layer (11).

8. A manufacturing method as claimed in any one of Claims 1 to 7, characterized in that, the substrate consisting of semi-insulating gallium arsenide (GaAs), the ions for obtaining the regions of the first conductivity type at the second resistivity level of the n[+] type are of silicon at a concentration of about $10^{17}$ to $10^{18}$ atoms per $cm^3$, the ions for obtaining the active layer(s) of the first conductivity type at the first resistivity level of the n-type are of silicon at the concentration of about $5.10^{16}$ to $5.10^{17}$ atoms per $cm^3$, and the ions for obtaining the layer of the second (p) conductivity type, if present, are of magnesium (Mg) or beryllium (Be) at a concentration of $10^{16}$ to $10^{17}$ atoms per $cm^3$, and in that the implantation annealing treatment is carried out at about 800°C for 20 minutes.

9. A manufacturing method as claimed in any one of Claims 1 to 8, characterized in that the metal forming the gate electrode is a superimposition of metallic layers chosen from
   - a superimposition of tungsten (W), tantalum (Ta) and gold (Au) having thicknesses of about 200 nm, about 100 nm and more than 500 nm, respectively,
   - a superimposition of tungsten nitride (WN), tantalum nitride (TaN) and gold (Au) having thicknesses of about 200 nm, about 100 nm and more than 500 nm, respectively and
   - a superimposition of tungsten (W) and gold (Au) having respective thicknesses of about 200 nm and more than 500 nm, respectively, and in that this multiple gate layer is formed by a method chosen from vapour deposition *in vacuo* and cathode sputtering.

10. A manufacturing method as claimed in any one of Claims 1 to 9, characterized in that for forming the ohmic source and drain contacts a layer of a gold-germanium alloy (Au-Ge) is first deposited by a method chosen from vapour deposition *in vacuo* and cathode sputtering, in that then a layer of nickel (Ni) is deposited by the same method, and in that the device is brought to a temperature of the order of 450°C to form the gold-germanium-nickel alloy (Au-Ge-Ni), the layer of alloy obtained having a thickness of about 0.5 to 1 $\mu m$.

11. A method as claimed in any one of the preceding Claims, characterized in that the dielectric of the first kind is silica ($SiO_2$) and the dielectric of the second kind is silicon nitride ($Si_3N_4$).

12. A manufacturing method as claimed in any one of Claims 1 to 11, characterized in that the etching treatments of all the layers necessary for the method, except the gold and silica layers, are carried out by reactive ion etching by means of $CHF_3 + SF_6$ gases, in that the silica layers are etched by reactive ion etching by means of the same gases to obtain etching edges inclined with respect to the substrate, or by reactive ion etching by means of pure $CH_3$ or $CF_4$ gas at a high pressure to obtain etching edges perpendicular to the substrate, and in that the gold layer, if present, is etched with a beam of ions of a neutral gas.

13. A semiconductor device of the field effect transistor type obtained by a manufacturing method as claimed in Claim 1, characterized in that the gate electrode G comprises an upper part (51) overlying the major base of the trapezoid, this upper part having a central metal region (105) and a peripheral zone (106) of a first kind of dielectric material, in that the peripheral zone projects beyond the surface of the major base of the trapezoid, in that the edges of the source S and drain D electrodes closest to the gate G are self-aligned with the outer edges of the peripheral zone of the gate, and in that this peripheral zone of the gate is at right angles to a layer (103) of a second kind of dielectric material arranged in the space between the gate and source contacts on the one hand and the gate and drain contacts on the other hand.

14. A device as claimed in Claim 13 obtained by the method as claimed in Claim 2, characterized in that the upper surface of the gate is covered by a metal layer (107) identical to that constituting the source and drain electrodes.

15. A device as claimed in Claim 13 obtained by the method as claimed in Claim 3, characterized in that the upper gate part is entirely metallic.

16. A semiconductor device of the field effect transistor type obtained by the method as claimed in Claim 4, characterized in that it comprises several adjacent gate fingers, whose upper parts are entirely metallic, and in that the different electrodes are insulated from each other by a layer (103, 104) of the dielectric material of the second kind.

17. A device as claimed in any one of Claims 13 to 15, characterized in that each active layer (102) comprises at its surface a depression forming a central zone in which its thickness is reduced, in that each gate electrode is formed in this zone, and in that the minor base of the trapezoid is in contact with the bottom of the depression to form a so-called buried-channel transistor.

18. A device as claimed in any one of Claims 13 to 17, characterized in that the thickness of the source and drain regions of the first conductivity type at the second resistivity level increases in proportion as their distance from the active layer increases so as to attain the maximum thickness under the source and drain electrodes.

19. A device as claimed in any one of Claims 13 to 18, characterized in that a region (11) of a second conductivity type extends under the active layer(s).

20. A device as claimed in any one of Claims 13 to 19, characterized in that the substrate consists of semiinsulating gallium arsenide (GaAs), the region of the first conductivity type at the first resistivity level is made of n-type gallium arsenide, the regions of the first conductivity type at the second resistivity level are made of $n^+$-type gallium arsenide and, if present, the region of the second conductivity type is made of p-type gallium arsenide.

21. A device as claimed in any one of Claims 13 to 20, characterized in that the metal forming the gate electrode is a superimposition of metallic layers chosen from

- a superimposition of tungsten (W), tantalum (Ta) and gold (Au) having thicknesses of about 200 nm, about 100 nm and more than 500 nm, respectively,
- a superimposition of tungsten nitride (WN), tantalum nitride (TaN) and gold (Au) having thicknesses of about 200 nm, about 100 nm and more than 500 nm, respectively and
- a superimposition of tungsten (W) and gold (Au) having thicknesses of about 200 nm and more than 500 nm, respectively,

and in that this multiple gate layer is formed by a method chosen from vapour deposition *in vacuo* and cathode sputtering.

22. A device as claimed in any one of Claims 13 to 21, characterized in that the metal forming the source and drain electrodes is a gold-germanium-nickel (Au-Ge-Ni) alloy.

23. A device as claimed in any one of Claims 13 to 22, characterized in that the first kind of dielectric material is silica ($SiO_2$) and the second kind is silicon nitride ($Si_3N_4$).

**Patentansprüche**

1. Verfahren zum Herstellen einer Halbleiteranordnung vom Feldeffekttransistortyp mit einer an der Oberfläche eines Halbleitersubstrats (w) gebildeten Schicht (102) eines ersten Leitungstyps aufeinem ersten Widerstandspegel, die als aktive Schicht bezeichnet ist, aufder eine Gate-Elektrode (G) vom Schottky-Typ vorgesehen ist, die im unteren Teil (15) die allgemeine Form eines Trapezes aufweist, wobei die Kleine Basis die aktive Schicht kontaktiert, weiterhin mit zwei auf je einer Seite der aktiven Schicht vorgesehenen Gebieten (101, 101') desselben Leitungstyps auf einem zweiten Widerstandspegel, wobei diese Gebiete das Source- bzw. Drain-Gebiet bilden, wobei die an die aktive Schicht grenzenden Ränder ausgerichtet sind zu den Rändern der Haupt- bzw. großen Basis des Trapezes, und außerdem mit Source- und Drain-Elelktroden (107) vom Ohmschen-Kontakttyp, die auf der Oberfläche der Gebiete vom ersten Leitungstyp auf einem zweiten Widerstandspegel gebildet sind, wobei dieses Verfahren mindestens die nachfolgenden Verfahrensschritte aufweist:

a/ das Bilden eines Substrats W aus einem monokristallinen Halbleiterwerkstoff mit einer Oberfläche parallel zu einer kristallographischen Ebene;

b/ das auf der Oberfläche dieses Substrats Bilden einer Schicht (1) aus einem dielektrischen Werkstoffeiner ersten Art;

c/ das auf der Oberfläche der vorhergehenden Schicht Bilden einer Maske $M_2$, welche die große Basis des Trapezes definiert, das den genannten unteren Teil der Gate-Elektrode bildet;

d/ das um die Maske $M_2$ herum Ätzen der dielektrischen Schicht der ersten Art durch reaktives Ionenätzen (RIE) zum Erhalten eines Kontaktes $M_1$ aus dielektrischem Werkstoff der ersten Art, auf der die Maske $M_2$ vorgesehen ist;

e/ das um den genannten, als Maske wirksamen Kontakt $M_1$ herum sowie in der Öffnung einer den Umfang des Transistors definierenden Maske $M_0$ Implantieren von Ionen zum Bilden von Source- und Drain-Gebieten (101, 101') vom ersten Leitungstyp auf dem zweiten Widerstandpegel, wonach die Masken $M_0$ bzw. $M_2$ entfernt werden;

f/ das auf der nur mit dem Kontakt $M_1$ versehenen Oberfläche der Anordnung Niederschlagen einer Schicht (103) aus dielekirischem Werkstoff einer zweiten Art einer einheitlichen Dicke mindestens entsprechend der des Kontaktes $M_1$,

g/ das nach einem an sich bekannten Verfahren Planieren der Anordnung auf dem Pegel der oberen Oberfläche des Kontaktes $M_1$;

h/ das durch selektives reaktives Ionen-Ätzen Entfernen des Kontaktes $M_1$ zum Bilden einer Öffnung derselben Oberfläche in der dielektrischen Schicht der zweiten Art, wobei das Substrat W freigelegt wird;

i/ das in dieser außerdem durch die Maske $M_0$ definierten Öffnung Implantieren von Ionen zum Bilden der aktiven Schicht (102) vom ersten Leitungstyp auf dem ersten Widerstandpegel, das Glühen der Implantation und das Entfernen der Maske $M_0$;

j/ das durch ein an sich bekanntes Verfahren Bilden von Distanzhaltern (104) an den Flanken der Öffnung in der dielektrischen Schicht der zweiten Art, wobei diese Distanzhalter aus einem dielektrischen Werkstoff der zweiten Art sind und wobei die Dicke derselben vorgesehen ist um die Abmessungen der Öffnung auf die Abmessungen für die lange L der Gate-Elektrode des Transistors zu reduzieren und zum gleichzeitigen Definieren des Abstandes der Gate-Elektrode von dem Source- und Drain-Gebiet;

k/ das Niederschlagen einer Schicht (105) aus dem Gate-Metall mit einer Dicke, die größer ist als die der Schicht aus dem Dielektrikum der zweiten Art, und danach einer Schicht (108) gewählt aus dem Dielektrikum der ersten Art oder aus Titan (Ti), wobei diese Schichten eine einheitliche Dicke aufweisen;

l/ das durch ein an sich bekanntes Verfahren Planieren der Anordnung bis zu dem oberen Pegel der Schicht aus dem Gate-Metall, derart, daß an der Oberfläche der in der metallischen Gate-Schicht gebildeten Senke über der Öffnung der dielektrischen Schicht der zweiten Art eine eine Maske $M_3$ bildende Schicht aus Dielektrikum der ersten Art oder aus Titan zurückbleibt;

m/ das um die Maske $M_3$ herum Ätzen der metallischen Gate-Schicht in einem Verfahren, das aus dem reaktiven selektiven Ionen-Ätzen (RIE) oder dem Ätzen mit einem Ionenstrahl neutralen Gases gewählt ist, wobei dieses Verfahren entsprechend dem die genannte metallische Gate-Schicht bildenden Metall gewählt wird, bis zu dem oberen Pegel der Schicht aus dem dielektrischen Werkstoff der zweiten Art, zum Bilden des metallischen zentralen Gebietes des oberen Teils der Gate-Elektrode;

n/ das durch eine an sich bekannte Technik Bilden von Distanzhaltern (106) an den Rändern der metallischen Gate-Schicht zum Bilden eines dielektrischen Umfangsgebietes am oberen metallischen Teil der Gate-Elektrode senkrecht zu der dielektrischen Schicht der zweiten Art, wobei diese Distanzhalter aus einem dielektrischen Werkstoff der ersten Art bestehen und ihre Dicke derart ist, daß der Abstand der Source- und Drain-Elektrode von der aktiven Schicht definiert ist, so daß de Abstand zwischen der Gate-Elektrode und der Source- und Drain-Elektrode der Summe der Dicken der bei diesem Verfahren hergestellten Distanzhalter entspricht;

o/ das Ätzen der Schicht aus dem dielektrischen Werkstoff der zweiten Art durch reaktives, selektives Ionen-Ätzen um den durch den oberen Teil der Gate-Elektrode gebildeten Kontakt, der durch die Maske $M_3$ und die Distanzhalter aus dem dielektrischen Werkstoff der ersten Art bedeckt ist, bis zu dem oberen Pegel des Substrats, wobei diese Ätzbehandlung unter den Distanzhaltern einigermaßen fortgesetzt werden kann.

2. Herstellungsverfahren nach Anspruch 1, dadurch gekennzeichnet, daß es weiterhin die nachfolgenden Verfahrensschritte aufweist:

p/ das aufder Oberfläche der betreffenden Anordnung Niederschlagen einer Schicht (107), wobei die Maske $M_3$ aus Titan (Ti) besteht, in der Öffnung der zweiten, den Umfang des Transistors definierenden Maske $M_0$, wobei diese Schicht (107) aus einem Metall besteht, das dazu geeignet ist, mit dem Halbleiterwerkstoff einen ohmschen Kontakt zu bilden zum Bilden der Source- (S) und Drain-Kontakte (D), sowie das Entfernen der Maske $M_0$.

3. Herstellungsverfahren nach Anspruch 1, dadurch gekennzeichnet, daß es weiterhin den nachfolgenden Verfahrensschritt aufweist:

p'/ das auf der Oberfläche der vorhergehenden Anordnung Niederschlagen einer Schicht (107), wobei die Maske $M_3$ aus Titan (Ti) oder aus dem dielektrischen Werkstoff der ersten Art besteht, in der Öffnung der den Umfang des Transistors definierenden Maske $M_0$, wobei diese Schicht (107) aus einem Metall besteht, das dazu geeignet ist, mit dem Halbleiterwerkstoff einen ohmschen Kontakt zu bilden, und das Entfernen der Maske $M_0$ und der dielektrischen Gebiete der ersten Art mittels eines an sich bekannten "Lift-off"-Verfahrens, wobei die auf den dielektrischen Schichten niedergeschlagenen metallischen Schichten entfernt werden.

**4.** Verfahren zum Herstellen einer Halbleiteranordnung vom Feldeffekttransistortyp, die an der Oberfläche eines Halbleitersubstrats (W) als aktive Schichten bezeichnete Schichten (102) eines ersten Leitungstyps auf einem ersten Widerstandspegel aufweist, auf denen Gate-Elektroden (G) vom SchottkyTyp gebildet sind, die in ihrem unteren Teil (15) die allgemeine Form eines Trapezes aufweisen, dessen kleine Basis eine aktive Schicht kontaktiert, die weiterhin zwischen jeweils zwei aufeinanderfolgenden aktiven Schichten ein Gebiet (101") eines ersten Leitungstyps auf einem ersten Widerstandspegel aufweisen und auf je einer Seite der äußeren aktiven Schichten zwei Gebiete (101, 101') des ersten Leitungstyps auf einem zweiten Widerstandspegel aufweisen, wobei dieses Verfahren mindestens die nachfolgenden Verfahrensschritte aufweist:

a/ das Bilden eines Substrats W aus einem monokristallinen Halbleiterwerkstoff mit einer Oberfläche parallel zu einer kristallographischen Ebene;

b'/ das auf der Oberfläche dieses Substrats Bilden einer Schicht (1) aus einem dielektrischen Werkstoff einer ersten Art;

c'/ das auf der Oberfläche der vorhergehenden Schicht Bilden einer Maske $M_2$, die mehrere Finger entsprechend der Basis des Trapezes definiert, das den genannten unteren Teil jeder Gate-Elektrode bildet;

d'/ das um die Maske $M_2$ herum Ätzen der dielektrischen Schicht der ersten Art durch reaktives Ionenätzen (RIE) zum Erhalten eines Kontaktes $M_1$ aus dielektrischem Werkstoff der ersten Art, aufder die Maske $M_2$ vorgesehen wird und welche dieselbe Form hat wie diese Maske;

e'/ das um den genannten, als Maske wirksamen Kontakt $M_1$ herum sowie in der Öffnung einer den Umfang des Transistors definierenden Maske $M_0$ Implantieren von Ionen zum Bilden der Gebiete vom ersten Leitungstyp auf dem zweiten Widerstandpegel, wonach die Masken $M_0$ bzw. $M_2$ entfernt werden;

f'/ das auf der nur mit dem Kontakt $M_1$ versehenen Oberfläche der Anordnung Niederschlagen einer Schicht (103) aus dielektrischem Werkstoff einer zweiten Art mit einer einheitlichen Dicke mindestens entsprechend der des Kontaktes $M_1$,

g'/ das nach einem an sich bekannten Verfahren Planieren der Anordnung auf dem Pegel der oberen Oberfläche des Kontaktes $M_1$;

h'/ das durch selektives reaktives Ionen-Ätzen Entfernen des Kontaktes $M_1$ zum Bilden von Öffnungen derselben Form und Oberfläche in der dielektrischen Schicht der zweiten Art, wobei das Substrat W freigelegt wird;

i'/ das in diesen außerdem durch die Maske $M_0$ definierten Öffnungen Implantieren von Ionen zum Bilden der aktiven Schichten (102) vom ersten Leitungstyp auf dem ersten Widerstandpegel, das Glühen der Implantation und das Entfernen der Maske $M_0$;

j'/ das durch ein an sich bekanntes Verfahren Bilden von Distanzhaltern (104) an den Flanken der Öffnung in der Schicht aus dielektrischem Werkstoff der zweiten Art, wobei diese Distanzhalter aus dem dielektrischen Werkstoff der zweiten Art hergestellt sind und wobei die Dicke derselben vorgesehen ist um die Abmessungen der Öffnungen auf die gewünschten Abmessungen für die lange L der Gate-Finger des Transistors zu reduzieren und zum gleichzeitigen Definieren des Abstandes der äußeren Gate-Finger von den Source- und Drain-Gebieten;

k'/ das Niederschlagen einer Schicht (105) aus Gate-Metall mit einer Dicke, die größer ist als die der Schicht aus dem dielektrischen Werkstoff der zweiten Art, und danach einer Schicht (108) gewählt aus dem dielektrischen Werkstoff der ersten Art oder aus Titan (Ti), wobei diese Schichten eine einheitliche Dicke aufweisen;

l'/ das durch ein an sich bekanntes Verfahren Planieren der Anordnung bis zu dem oberen Pegel der Schicht aus dem Gate-Metall, derart, daß an der Oberfläche der in der metallischen Gate-Schicht gebildeten Senke über der Öffnung der dielektrischen Schicht der zweiten Art ebenfalls eine eine Maske $M_3$ bildende Schicht aus dielektrischem Werkstoff der ersten Art oder aus Titan zurückbleibt;

m'/ das um die Maske $M_3$ herum Ätzen der metallischen Gate-Schicht in einem Verfahren, das aus dem reaktiven selektiven Ionen-Ätzen (RIE) oder dem Ätzen mit einem Ionenstrahl neutralen Gases gewählt ist, wobei dieses Verfahren entsprechend dem die genannte metallische Gate-Schicht bildenden Metall gewählt wird, bis zu dem oberen Pegel der Schicht aus dem dielektrischen Werkstoff der zweiten Art, zum Bilden des metallischen zentralen Gebietes des genannten oberen Teils der Gate-Finger;

n'/ das durch eine an sich bekannte Technik Bilden von Distanzhaltern (106) an den Rändern der metallischen Schicht des metallischen oberen Teils der Gate-Finger senkrecht zu der dielektrischen Schicht der zweiten Art, wobei diese Distanzhalter aus einem dielektrischen Werkstoff der ersten Art bestehen und ihre Dicke vorgesehen ist um den Abstand der Source- und Drain-Elektroden von den aktiven Zonen zu definieren und zwar derart, daß de Abstand zwischen der Source-Elektrode und einem Gate-Finger oder einem Gate-Finger und der Drain-Elektrode der Summe der Dicken der bei diesem Verfahren hergestellten Distanzhalter entspricht;

o'/ das Ätzen der Schicht aus dem dielektrischen Werkstoff der zweiten Art durch reaktives, selektives Ionen-Ätzen um den durch den oberen Teil der Gate gebildeten Kontakt, der durch die Maske $M_3$ und die Distanzhalter aus dem dielektrischen Werkstoff der ersten Art bedeckt ist, bis zu dem oberen Pegel des Substrats;

p'/ das auf der Oberfläche der vorhergehenden Anordnung Niederschlagen einer Schicht (107), wobei die Maske $M_3$ aus Titan (Ti) oder aus dielektrischem Werkstoff der ersten Art besteht, in der Öffnung der den Umfang des Transistors definierenden Maske $M_0$, wobei diese Schicht (107) aus einem Metall besteht, das dazu geeignet ist, mit dem Halbleiterwerkstoff einen ohmschen Kontakt zu bilden, zum Bilden der Source- (S) und Drain-Kontakte (D) und das Entfernen der Maske $M_0$ und der dielektrischen Gebiete der ersten Art und ggf. $M_3$ mittels eines an sich bekannten "Lift-off"-Verfahrens, wobei die aufden dielektrischen Schichten niedergeschlagenen metallischen Schichten entfernt werden.

5.  Herstellungsverfahren nach einem der Ansprüche 1 bis 4, dadurch gekennzeichnet, daß zwischen dem Verfahrensschritt j) und dem Verfahrensschritt k) oder dem Verfahrensschritt j') und k') ein zusätzlicher Verfahrensschritt durchgeführt wird, und zwar:

    $j_0$/ das Bilden einer Senke in der (oder den) aktiven Schicht(en) um ihre Dicke zu verringern, und zwar mittels eines Verfahrens, das gewählt wird aus dem reaktiven, selektiven Ionenätzen oder dem chemischen Ätzen.

6.  Herstellungsverfahren nach einem de Ansprüche 1 bis 5' dadurch gekennzeichnet, daß die Umstände des selektiven Ionenätzen derart gewählt werden, daß der Kontakt $M_1$ ein Tra-

pez bildet, dessen große Basis das Halbleitermaterial kontaktiert.

7.  Herstellungsverfahren nach einem der Ansprüche 1 bis 6, dadurch gekennzeichnet, daß zwischen dem Verfahrensschritt h) und dem Verfahrensschritt i) oder dem Verfahrensschritt h' und dem Verfahrensschritt i' ein zusätzlicher Verfahrensschritt durchgeführt wird:

    $h_0$/ das in dieser außerdem durch die Maske $M_0$ definierten Öffnung Implantieren von Ionen, und zwar mit großer Energie zum Bilden einer tiefen Schicht (11), wobei diese Ionen geeignet sind zum Bilden der Schicht vom zweiten Leitungstyp.

8.  Herstellungsverfahren nach einem der Ansprüche 1 bis 7, dadurch gekennzeichnet, daß das Substrat aus halbisolierenden Galliumarsenid (GaAs) besteht, die Ionen zum Erhalten der Gebiete vom ersten Leitungstyp auf dem zweiten Widerstandspegel vom $n^+$-Typ aus Silizium bestehen mit einer Konzentration von etwa $10^{17}$ bis $10^{18}$ Atomen/$cm^3$, die Ionen zum Erhalten der aktiven Schicht(en) vom ersten Leitungstyp und aufdem ersten Widerstandspegel n aus Silizium bestehen mit einer Konzentration von etwa $5.10^{16}$ bis $5.10^{17}$ Atomen/$cm^3$ und die Ionen zum Erhalten der Schicht vom zweiten Leitungstyp p, falls vorhanden, aus Magnesium (Mg) oder Beryllium (Be) bestehen mit einer Konzentration von $10^{16}$ bis $10^{17}$ Atomen/$cm^3$, und daß das Glühen der Implantation bei etwa 800°C während 20 Minuten durchgeführt wird.

9.  Herstellungsverfahren nach einem der Ansprüche 1 bis 8, dadurch gekennzeichnet, daß das die Gate-Elektrode bildende Metall eine Überlagerung metallischer Schichten ist, gewählt aus:

    - einer Überlagerung von Wolfram (W), Tantal (Ta) und Gold (Au) mit Dicken von etwa 200 nm, etwa 100 nm bzw. über 500 nm;
    - einer Überlagerung von Wolframnitrid (WN), Tantalnitrid (TaN) und Gold (Au) mit Dicken von etwa 200 nm, etwa 100 nm bzw. über 500 nm;
    - einer Überlagerung von Wolfram (W) und Gold (Au) mit Dicken von etwa 200 nm bzw. über 500 nm, und daß diese Gate-Mehrfachschicht gebildet wird mit einem Verfahren, das gewählt wird aus Dampfphasenbeschichtung im Vakuum und Kathodenzerstäubung.

10. Herstellungsverfahren nach einem der Ansprüche 1 bis 9, dadurch gekennzeichnet, daß zum Bilden der ohmschen Source- und Drain-Kontakte zunächst eine Schicht aus einer Gold-Germanium-legierung (Au-Ge) angebracht wird mit einem Verfahren, das gewählt wird aus Dampfphasenbeschichtung im Vakuum und Kathodenzerstäubung, daß danach eine Nickelschicht (Ni) mit demselben Verfahren angebracht wird, und daß die Anordnung auf eine Temperatur in der Größenordnung von $450\,^\circ$C gebracht wird zum Bilden der Gold-Germanium-Nickel-Legierung (Au-Ge-Ni), wobei die erhaltene Legierungsschicht eine Dicke hat von etwa 0,5 bis 1 $\mu$m.

11. Verfahren nach einem der vorstehenden Ansprüche, dadurch gekennzeichnet, daß der dielektrische Werstoff der ersten Art Siliziumdioxid ($SiO_2$) und der dielektrische Werkstoff der zweiten Art Siliziumnitrid ($Si_3N_4$) ist.

12. Herstellungsverfahren nach einem der Ansprüche 1 bis 11, dadurch gekennzeichnet, daß die Ätzbehandlung aller bei diesem Verfahren erforderlichen Schichten, mit Ausnahme der Gold- und Siliziumdioxidschichten, durch reaktives Ionenätzen mit Hilfe von Gas $CHF_3$ + $SF_6$ erfolgt, daß die Ätzbehandlung der Siliziumdioxidschicht durch reaktives Ionenätzen mit Hilfe derselben Gase erfolgt, die verwendet werden zum Erhalten der gegenüber dem Substrat schrägen Ätzflanken, oder durch reaktives Ionenätzen mit Hilfe des reinen Gases $CH_3$ oder $CF_4$ unter hohem Druck zum Erhalten von Ätzflanken senkrecht zu dem Substrat, und daß die Ätzbehandlung der Goldschicht, falls vorhanden, durch einen Ionenstrahl aus neutralem Gas erfolgt.

13. Halbleiteranordnung vom Feldeffekttransistortyp erhalten nach einem herstellungsverfahren nach Anspruch 1, dadurch gekennzeichnet, daß die Gate-Elektrode G einen oberen Teil (51) aufweist, der sich über die große Basis des Trapezes erstreckt, wobei dieser obere Teil ein zentrales metallisches Gebiet (105) aufweist sowie eine Randzone (106) aus einem dielektrischen Werkstoff einer ersten Art, daß die Randzone über die Oberfläche der großen Basis des Trapezes hinausragt, daß die Ränder der Source- (S) und Drain-elektroden (D), die dem Gate (G) am nächsten liegen selbstausrichtend mit den äußeren Rändern der Randzone der Gate sind und daß diese Randzone der Gate senkrecht auf einer Schicht (103) aus einem dielektrischen Werkstoffeiner zweiten Art steht, die in dem Raum zwischen den Gate- und Source-Kontakten einerseits und den Gate-und Drain-Kontakten andererseits vorgesehen ist.

14. Anordnung nach Anspruch 13, erhalten nach dem Verfahren nach Anspruch 2, dadurch gekennzeichnet, daß die obere Fläche der Gate mit einer metallischen Schicht (107) bedeckt ist, die derjenigen entspricht, welche die Source- und Drain-Elektroden bildet.

15. Anordnung nach Anspruch 13, erhalten nach dem Verfahren nach Anspruch 3, dadurch gekennzeichnet, daß der obere Teil der Gate vollständig metallisch ist.

16. Halbleiteranordnung vom Feldeffekttransistortyp erhalten nach dem Verfahren nach Anspruch 4, dadurch gekennzeichnet, daß sie mehrere nebeneinander liegende Gate-Finger aufweist, deren obere Teile vollständig metallisch sind und daß die unterschiedlichen Elektroden durch eine dielektrische Schicht (103, 104) der zweiten Art gegenüber einander isoliert sind.

17. Anordnung nach einem der Ansprüche 13 bis 16, dadurch gekennzeichnet, daß jede aktive Schicht (102) auf der Oberfläche eine Senke aufweist, die eine zentrale Zone bildet, in der die Dicke verringert ist, daß jede Gate-Elektrode in dieser Zone gebildet ist, wobei die Kleine Basis des Trapezes den Boden der Senke kontaktiert, und zwar zum Bilden eines sog. vergrabenen-Kanal-Transistors.

18. Anordnung nach einem der Ansprüche 13 bis 17, dadurch gekennzeichnet, daß die Dicke der Source- und Drain-Gebiete vom ersten Leitungstyp auf dem zweiten Widerstandspegel zunimmt je nachdem ihr Abstand von der aktiven Schicht zunimmt, wobei die maximale Dikke unterhalb der Source- und Drain-Elektroden erzielt wird.

19. Anordnung nach einem der Ansprüche 13 bis 18, dadurch gekennzeichnet, daß ein Gebiet (11) vom zweiten Leitungstyp sich unterhalb der aktiven Schicht(en) erstreckt.

20. Anordnung nach einem der Ansprüche 13 bis 19, dadurch gekennzeichnet, daß das Substrat aus halbisolierendem Galliumarsenid (GaAs) besteht, das Gebiet vom ersten Leitungstyp auf dem ersten Widerstandspegel aus n-leitendem Galliumarsenid besteht, die Gebiete vom ersten Leitungstyp aufdem zweiten Widerstandspegel aus $n^+$-leitendem Galliumarsenid bestehen und, falls vorhanden, das Gebiet vom zweiten Leitungstyp aus p-leitendem Galliumarsenid besteht.

21. Anordnung nach einem der Ansprüche 13 bis 20, dadurch gekennzeichnet, daß das die Gate-Elektrode bildende Metall eine Überlagerung metallischer Schichten ist, gewählt aus:
    - einer Überlagerung von Wolfram (W), Tantal (Ta) und Gold (Au) mit Dicken von etwa 200 nm, etwa 100 nm bzw. über 500 nm;
    - einer Überlagerung von Wolframnitrid (WN), Tantalnitrid (TaN) und Gold (Au) mit Dicken von etwa 200 nm, etwa 100 nm bzw. über 500 nm;
    - einer Überlagerung von Wolfram (W) und Gold (Au) mit Dicken von etwa 200 nm bzw. über 500 nm, und daß diese Gate-Mehrfachschicht gebildet wird mit einem Verfahren, das gewählt wird aus Dampfphasenbeschichtung im Vakuum und Kathodenzerstäubung.

22. Anordnung nach einem der Ansprüche 13 bis 21, dadurch gekennzeichnet, daß das die Source- und Drain-Elektroden bildende Metall eine Gold-Germanium-Nickel-Legierung (Au-Ge-Ni) ist.

23. Anordnung nach einem der vorstehenden Ansprüche, dadurch gekennzeichnet, daß der dielektrische Werkstoff der ersten Art Siliziumdioxid ($SiO_2$) und der zweiten Art Siliziumnitrid ($Si_3N_4$) ist.

FIG.1a

FIG.1b

L

104/102

107 / 101'

I     I

l

S    D

105/102

103/101'

G

**FIG.1c**

M₂

M₀

P

**FIG.1d**

28

$M_2$

1

W

**FIG.2a**

$M_2$  $M_1$

10

**FIG.2b**

$M_1$  $M_0$

101  101'

W

**FIG.2c**

2

$M_1$

103

101  101'

W

**FIG.2d**

$M_1$

103

101  101'

W

**FIG.2e**

FIG.2f

FIG.2g

FIG.2h

FIG.2i

FIG. 2j

FIG.2k

FIG.2l

FIG.2m

FIG.2n

FIG.3a

FIG.3b

FIG.4a

FIG.4b

FIG.5a

FIG.5b